# EUROPEAN PATENT APPLICATION

(11) **EP 2 112 695 A1**
(43) Date of publication of application: **28.10.2009**
(21) Application number: 08710768.6
(22) Date of filing: 04.02.2008
(51) Int. Cl.: H01L 29/47, H01L 21/338, H01L 29/22, H01L 29/778, H01L 29/812, H01L 29/861, H01L 29/872, H01L 33/00

(54) **ZnO SEMICONDUCTOR ELEMENT**

(30) Priority: 02.02.2007 JP 2007024702; 31.01.2008 JP 2008021953
(71) Applicant: Rohm Co., Ltd., Kyoto-shi, Kyoto 615-8585 (JP)
(72) Inventor: NAKAHARA, Ken, Kyoto-shi Kyoto 615-8585 (JP); YUJI, Hiroyuki, Kyoto-shi Kyoto 615-8585 (JP); KAWASAKI, Masashi, Sendai-shi Miyagi 980-8577 (JP); OHTOMO, Akira, Sendai-shi Miyagi 980-8577 (JP); TSUKAZAKI, Atsushi, Sendai-shi Miyagi 980-8577 (JP); FUKUMURA, Tomoteru, Sendai-shi Miyagi 980-8577 (JP); NAKANO, Masaki, Sendai-shi Miyagi 980-8577 (JP)
(74) Representative: TBK-Patent
(86) International application number: PCT/JP2008/051790
(87) International publication number: WO 2008/093873

(57) **Abstract**

To solve the foregoing problems, provided is a ZnO-based semiconductor element having an entirely novel function distinct from hitherto, using a ZnO-based semiconductor and organic matter for an active role. An organic electrode 2 is formed on a ZnO-based semiconductor 1, and an Au film 3 is formed on the organic electrode 2. An electrode formed of a multilayer metal film including a Ti film 4 and an Au film 5 is formed on the back surface of the ZnO-based semiconductor 1 so as to be opposed to the organic electrode 2. A bonding interface between the organic electrode 2 and the ZnO-based semiconductor 1 is in a pn junction-like state. Thus, rectification occurs therebetween.

## Description

### TECHNICAL FIELD

The present invention relates to a ZnO-based semiconductor element in which an electrode made of organic matter is formed on a ZnO-based semiconductor.

### BACKGROUND ART

Recently, an oxide has attracted attention as a multifunctional substance, and the results of research have been published one after another; however, such an oxide also has problems. For example, with a nitride for use in a blue LED, a device having specific functions can be fabricated by stacking several thin films each having different functions one on another and subjecting the thin films to etching. On the other hand, with the oxide, a method for thin film formation is limited to sputtering, PLD (pulse laser deposition), or the like, thus making it difficult to fabricate a stacked structure as in a semiconductor element. The sputtering typically has difficulty in obtaining a crystalline thin film and the PLD, which basically includes point evaporation, has difficulty in achieving a large area of even approximately 2 inches.

Plasma assisted molecular beam epitaxy (PAMBE) is performed as an approach of fabricating the semiconductor element-like structure with the oxide. The most noteworthy one of objects of study using this is ZnO. A problem arising when the ZnO is used as a material for a semiconductor device lies in the fact that p-type ZnO can not be obtained because of the difficulty in acceptor doping.

Recently, however, as found in Non-patent Document 1 or 2, advances in technology have made it possible to obtain the p-type ZnO from which light emission was observed, so that research is very active. Also, interesting substances that are active in both application and research, likewise as the multifunctional substances, include a conductive polymer. An organic material, integrated with printing technology or the like, may be very simply formed into a device, and hence, an opinion of some people arises that organic matter will be the leading role of electronic devices in the next generation. Electronic device making requires an electric conductive object, and thus the conductive polymer is effective also for that reason.

The semiconductor, which is an inorganic substance, and the organic matter each have developed independently and until now have not had much contact with each other, however, research for integrating them together has recently been active. Plenty of organic materials and oxides not only make it possible to form various types of devices, but also often allow low-cost forming. The organic matter may be patterned by the printing technology or the like, thus achieving reductions in process costs.

The foregoing ZnO-based material is one of objects that are most advanced in studies among oxide crystals, and is the substance having a great many functions as well as light emission properties previously mentioned. Thus, there has been a proposal of integration with the organic matter. However, when combined with a thin film or substrate of the ZnO-based material, the organic matter is used chiefly as an electrode in passive form, and there are very few instances where a combined part is used as a device having some active function.
Patent Document 1: Japanese Patent Application Publication No. 2005-277339
Patent Document 2: Japanese Patent Application Publication No. 2006-58730
Patent Document 3: Japanese Patent Translation Publication No. 2006-518471
Non-patent Document 1:A. Tsukazaki et al., JJAP 44 (2005) L643
Non-patent Document 2: A. Tsukazaki et al., Nature Material 4 (2005) 42
Non-patent Document 3: Chi-Yane Chang et al., Applied Physics Letters 88, 173503 (2006) "Electroluminescence from ZnO nanowire/polymer composite p-n junction"
Non-patent Document 4: R. Konenkamp et al., Applied Physics Letters 85, 6004 (2004) "Vertical nanowire light-emitting diode"

### DISCLOSURE OF THE INVENTION

### Problems to be Solved by the Invention

Devices have been disclosed for example in Non-patent Documents 3 and 4, both of which use crystalline whiskers of ZnO so called "nanowire." The nanowire is a low dimensional system, has difficulty in device processing, and is also incapable of controlling an organic matter-semiconductor interface. Therefore, to form a device by combining a ZnO-based material and organic matter to actively control the physical state of an interface therebetween, the simplest approach for device formation is to have the device to be formed in a configuration two-dimensionally spreading in planar form, as is the case with a substrate or a thin film, and besides, this configuration is required for control of the state of the interface. Also, this facilitates an improvement in precision in the device process.

Basically using the thin film or the substrate, the organic matter can be processed to be applied to and spread on the thin film by a simple and easy method such as spin coating, vapor deposition, or spray coating, which also has an affinity for the existing state of thin film device process. Also, many processes for forming the organic matter are simple, which in turn leads to a reduction in process time and hence to a great cost-reduction effect.

On the other hand, Patent Document 1 or the like shows an example where a conductive polymer, which is organic matter for use as an electrode, is formed on a thin film or substrate of a ZnO-based material. This is not made of crystalline whiskers of ZnO as in the above-mentioned prior art, but the organic matter is passively combined with the ZnO-based material as an electrode for supplying a current to a transistor, rather than used to play an active role such as controlling the organic matter-semiconductor interface.

The present invention has been made in order to solve the foregoing problems. An object of the present invention is to provide a ZnO-based semiconductor element using a ZnO-based semiconductor and organic matter for an active role and thus having an entirely novel function distinct from the conventional art.

### Means for Solving the Problems

In order to attain the above object, an invention of claim 1 is a ZnO-based semiconductor element, **characterized in that** an organic electrode is formed in contact with a ZnO-based semiconductor, and rectification characteristics are obtained between the ZnO-based semiconductor and the organic electrode.

Also, an invention of claim 2 is the ZnO-based semiconductor element of claim 1, **characterized in that** a work function of the organic electrode is greater than an electron affinity of the ZnO-based semiconductor.

Also, an invention of claim 3 is the ZnO-based semiconductor element of any one of claims 1 and 2, **characterized in that** a principal plane of the ZnO-based semiconductor on the side thereof in contact with the organic electrode is a +C-plane.

Also, an invention of claim 4 is the ZnO-based semiconductor element of claim 3, **characterized in that** a normal to the organic electrode is inclined at least in the direction of an m-axis with respect to a +c-axis of the principal plane.

Also, an invention of claim 5 is the ZnO-based semiconductor element of claim 4, **characterized in that** an angle of inclination of the normal to the organic electrode is not more than 5°C.

Also, an invention of claim 6 is the ZnO-based semiconductor element of any one of claims 1 and 2, **characterized in that** the principal plane of the ZnO-based semiconductor with which the organic electrode is in contact is any one of an M-plane and an A-plane.

Also, an invention of claim 7 is the ZnO-based semiconductor element of claim 6, **characterized in that** the normal to the organic electrode is inclined at least in the direction of the c-axis with respect to any one of an m-axis and an a-axis of the principal plane.

Also, an invention of claim 8 is the ZnO-based semiconductor element of any one of claims 1 to 7, **characterized in that** at least a portion of the organic electrode is formed of a conductive polymer.

Also, an invention of claim 9 is the ZnO-based semiconductor element of claim 8, **characterized in that** resistivity of the organic electrode is not more than 1 Ωcm.

Also, an invention of claim 10 is the ZnO-based semiconductor element of any one of claims 8 and 9, **characterized in that** the conductive polymer is formed of at least one of a polyaniline derivative, a polypyrrole derivative, and a polythiophene derivative.

Also, an invention of claim 11 is the ZnO-based semiconductor element of any one of claims 8 and 9, **characterized in that** the conductive polymer is formed of at least one of a polyaniline derivative containing a carrier dopant, a polypyrrole derivative containing a carrier dopant, and a polythiophene derivative containing a carrier dopant.

Also, an invention of claim 12 is the ZnO-based semiconductor element of any one of claims 1 to 11, **characterized in that** the organic electrode has translucency in an ultraviolet region.

Also, an invention of claim 13 is the ZnO-based semiconductor element of claim 12, **characterized in that** the organic electrode is made of a hole conductor.

Also, an invention of claim 14 is the ZnO-based semiconductor element of any one of claims 12 and 13, **characterized in that** when a voltage of 3 volts is applied to the ZnO-based semiconductor element under a reverse-biased condition where a negative voltage is applied to the ZnO-based semiconductor element on the organic electrode side thereof, and a reverse current is not more than 1 nanoampere under a condition where no light is applied.

Also, an invention of claim 15 is the ZnO-based semiconductor element of any one of claims 12 to 14, **characterized in that** the ZnO-based semiconductor is constructed only of a ZnO-based substrate.

Also, an invention of claim 16 is the ZnO-based semiconductor element of any one of claims 12 to 15, **characterized in that** the ZnO-based semiconductor element is a photodiode.

Also, an invention of claim 17 is the ZnO-based semiconductor element of any one of claims 1 to 11, **characterized in that** the ZnO-based semiconductor is formed of a laminate in which at least a single ZnO-based thin film is formed on the ZnO-based substrate, and the organic electrode serves as a Schottky type gate electrode and has a transistor function.

Also, an invention of claim 18 is the ZnO-based semiconductor element of claim 17, **characterized in that** the laminate includes at least a set of thin film laminated structures in which two or more ZnO-based thin films are stacked on each other on the ZnO-based substrate, and a Mg_{X}ZnO layer (where 0 ≤ X < 1) and a Mg_{Y}ZnO layer (where 0 < Y < 1) are stacked in order, as viewed from the side close to the ZnO-based substrate, (wherein X < Y).

Also, an invention of claim 19 is the ZnO-based semiconductor element of any one of claims 17 and 18, **characterized in that** an electron storage region occurring at an interface between the Mg_{X}ZnO layer and the Mg_{Y}ZnO layer in the thin film laminated structure is used as a channel region.

### Effects of the Invention

According to the present invention, the organic electrode is formed in contact with the ZnO-based semiconductor. Accordingly, a potential barrier is formed at an interface between the ZnO-based semiconductor and the organic electrode and thus rectification occurs between the ZnO-based semiconductor and the organic electrode due to an energy band relationship. The present invention is therefore applicable to a novel device such as a diode.

### BRIEF DESCRIPTION OF THE DRAWINGS

[Fig. 1] Fig. 1 is a view showing an example of a sectional structure of a ZnO-based semiconductor element according to the present invention.
[Fig. 2] Fig. 2 is a view showing other sectional structures of the ZnO-based semiconductor element.
[Fig. 3] Fig. 3 is a graph showing an energy band in a bonding interface region between a ZnO-based semiconductor and an organic electrode.
[Fig. 4] Fig. 4 is a graph showing a comparison of voltage-current characteristics between the ZnO-based semiconductor element of the present invention and a Schottky junction element.
[Fig. 5] Fig. 5 is a graph showing the comparison of the voltage-current characteristics between the ZnO-based semiconductor element of the present invention and the Schottky junction element.
[Fig. 6] Fig. 6 is a view showing a manufacturing process for the ZnO-based semiconductor element according to the present invention.
[Fig. 7] Fig. 7 is a conceptual illustration of a crystal structure of a ZnO-based compound.
[Fig. 8] Fig. 8 is a graph showing a comparison of voltage-current characteristics between a case where the organic electrode is in contact with a +C-plane of principal planes of a ZnO-based semiconductor layer and a case where the organic electrode is in contact with a -C-plane thereof.
[Fig. 9] Fig. 9 is a graph showing the comparison of the voltage-current characteristics between a case where the organic electrode is in contact with a +C-plane of principal planes of a ZnO-based semiconductor layer and a case where the organic electrode is in contact with a -C-plane thereof.
[Fig. 10] Fig. 10 is a view showing the surface of the ZnO-based semiconductor layer in a case where a c-axis makes an off angle toward an m-axis with respect to the direction of a normal to the organic electrode.
[Fig. 11] Fig. 11 is a view showing a kink point on a wafer in the process of crystal growth.
[Fig. 12] Fig. 12 is a view showing the surface of the ZnO-based semiconductor layer in a case where the m-axis or an a-axis makes an off angle in the direction of a -c-axis with respect to the direction of the normal to the organic electrode.
[Fig. 13] Fig. 13 is a view showing other sectional structures of the ZnO-based semiconductor element.
[Fig. 14] Fig. 14 is a graphic representation of a chemical structural formula of a polythiophene derivative and polystyrene sulfonate.
[Fig. 15] Fig. 15 is a graphic representation of a chemical structural formula of a polyaniline derivative.
[Fig. 16] Fig. 16 is a graphic representation of a chemical structural formula of a polypyrrole derivative.
[Fig. 17] Fig. 17 is a view showing the relationship between a normal to the principal plane of a substrate and the c-, m- and a-axes as crystallographic axes of the substrate.
[Fig. 18] Fig. 18 is a view showing a sectional structure of the ZnO-based semiconductor element of the present invention as configured as a light receiving element.
[Fig. 19] Fig. 19 is a graph showing wavelength dependence of light transmittance and reflectance of PEDOT/PSS.
[Fig. 20] Fig. 20 is a graph showing a current change in a case where the ZnO-based semiconductor element shown in Fig. 18 is irradiated with light.
[Fig. 21] Fig. 21 is a graph showing a current-voltage characteristic in a case where the ZnO-based semiconductor element shown in Fig. 18 is irradiated with light.
[Fig. 22] Fig. 22 is a graph showing characteristics of a reverse current in a case where the ZnO-based semiconductor element is irradiated with light through a wavelength-dependent filter.
[Fig. 23] Fig. 23 is an illustration showing the state around the interface between the organic electrode and the ZnO.
[Fig. 24] Fig. 24 is a graph showing the relationship between the reverse voltage and current of the ZnO-based semiconductor element shown in Fig. 18.
[Fig. 25] Fig. 25 is a graph showing a piezoelectric effect of an MgZnO-ZnO interface.
[Fig. 26] Fig. 26 is a graph showing the relationship between sheet charge density and Mg composition proportion of the MgZnO-ZnO interface.
[Fig. 27] Fig. 27 is an illustration showing the state of polarization of the MgZnO-ZnO interface varying according to the Mg composition.
[Fig. 28] Fig. 28 is a graph showing results of CV measurement and results of IV measurement in PEDOT/MgZnO/ZnO.
[Fig. 29] Fig. 29 is a view and a plot showing a measurement configuration of electron mobility of two-dimensional electron gas at the MgZnO-ZnO interface, and measured results.
[Fig. 30] Fig. 30 is a graph and a view showing a measurement configuration of longitudinal resistance and integral quantum Hall effect, and measured results.
[Fig. 31] Fig. 31 is a graph for observing two-dimensional properties of the two-dimensional electron gas.
[Fig. 32] Fig. 32 is a view and a graph showing a basic configuration and a current-voltage characteristic, respectively, of the ZnO-based semiconductor element of the present invention when applied to a HEMT.
[Fig. 33] Fig. 33 is a graph showing a comparison of field effect mobility and Hall mobility.
[Fig. 34] Fig. 34 is a view showing an example of configuration of the HEMT.
[Fig. 35] Fig. 35 is a view showing an example of configuration of the HEMT.
[Fig. 36] Fig. 36 is a view showing an example of configuration of the HEMT.
[Fig. 37] Fig. 37 is a view showing an example of configuration of the HEMT.

### Explanation of Reference Numerals

1 ZnO-based semiconductor
2 organic electrode
3 Au film
4 Ti film
5 Au film
6 substrate
8 ZnO substrate
9 p-type MgZnO layer
11 n-type MgZnO layer

### BEST MODE FOR CARRYING OUT THE INVENTION

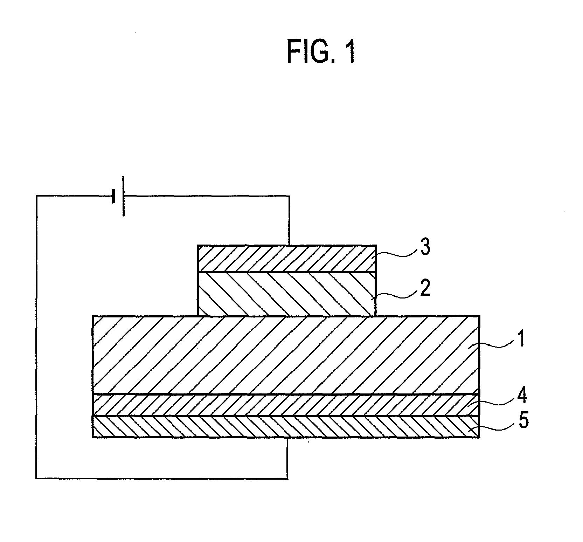

One embodiment of the present invention will be described below with reference to the drawings. Fig. 1 shows an example of a sectional structure of a ZnO-based semiconductor element according to the present invention.

An organic electrode 2 is formed on a ZnO-based semiconductor 1, and an Au film 3 for use in wire bonding or the like is formed on the organic electrode 2. On the other hand, an electrode made of a multilayer metal film including a Ti film 4 and an Au film 5 is formed on the back surface of the ZnO-based semiconductor 1 so as to face the organic electrode 2. The ZnO-based semiconductor 1 is made of a compound containing ZnO or ZnO, and is construed as containing, besides the ZnO, any one of oxides of a Group-IIA element and Zn, a Group-IIB element and Zn, and Group-IIA and Group-IIB elements and Zn, given as specific examples. The ZnO-based semiconductor 1 is formed of an n-type ZnO substrate by way of example.

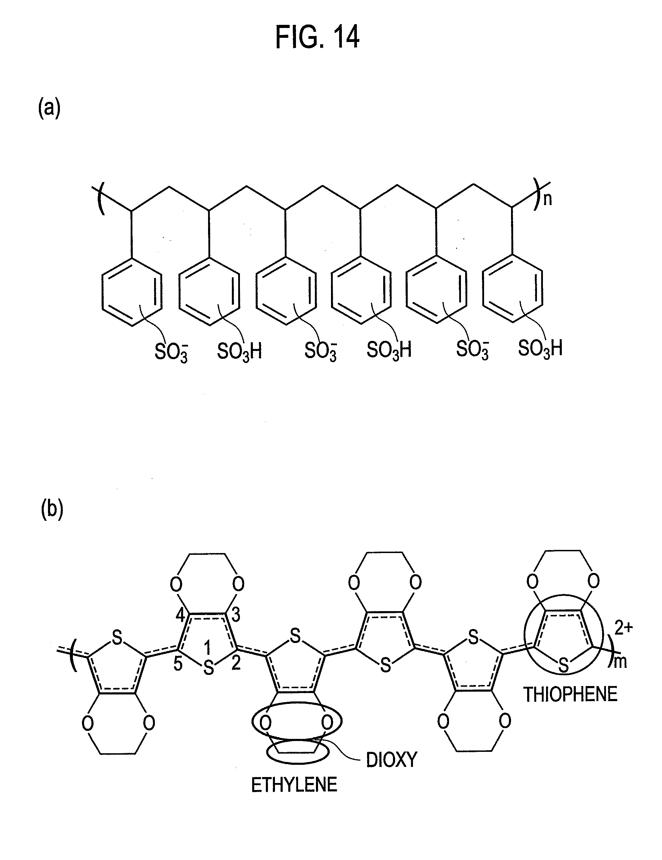

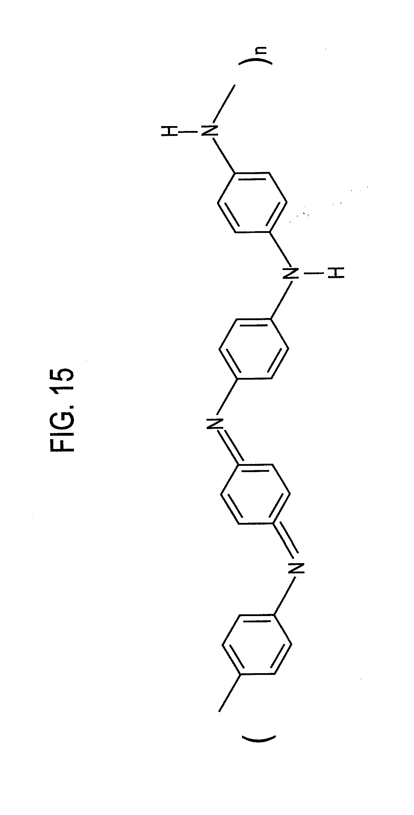

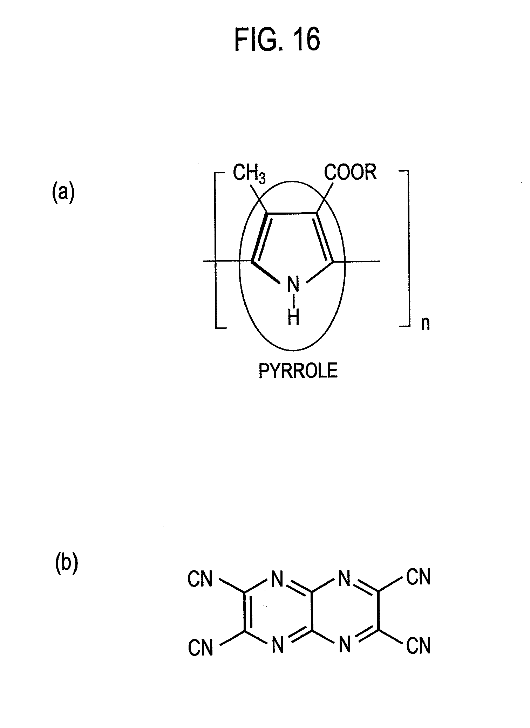

On the other hand, the organic electrode 2 is partially formed of a conductive polymer. A polythiophene derivative (PEDOT: poly(3,4)-ethylenedioxythiophene) shown in Fig. 14(b), a polyaniline derivative shown in Fig. 15, a polypyrrole derivative shown in Fig. 16(a), or the like, for example, is used as the conductive polymer.

Specifically, a substance consisting of any one of the above-mentioned derivatives doped with a substance for controlling electrical characteristics such as conduction characteristics is used, and the polythiophene derivative (PEDOT) doped with polystyrene sulfonate (PSS) shown in Fig. 14(a), or the polypyrrole derivative doped with TCNA shown in Fig. 16(b), for example, is used.

In Fig. 1, the Au film 3 is connected to the positive part of a direct-current power supply, and the Au film 5 is connected to the negative part of the direct-current power supply. This shows the ZnO-based semiconductor element of Fig. 1, which has rectification as is the case with a diode, as later described, while being forward-biased. In terms of a pn junction, therefore, the organic electrode 2 functions as a p-electrode, and the Ti film 4 functions as an n-electrode.

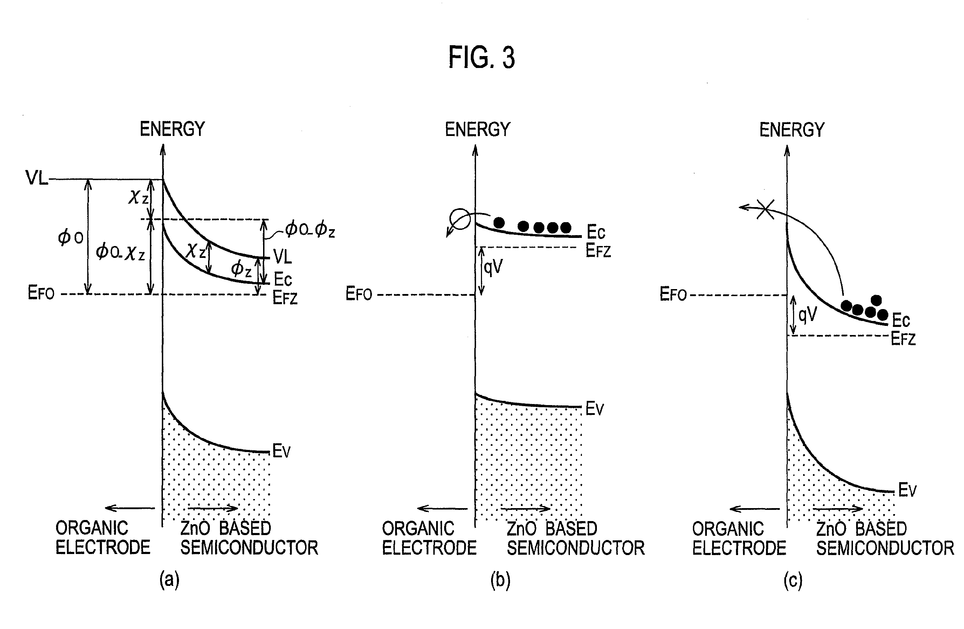

Fig. 3 is graphs for explaining the function of the ZnO-based semiconductor element formed in the manner as above described. Fig. 3 shows an energy band at a bonding interface between the ZnO-based semiconductor 1 and the organic electrode 2, which is observed when the ZnO-based semiconductor 1 is formed of the n-type ZnO substrate and the organic electrode 2 is formed of the PEDOT:PSS.

Fig. 3(a) shows a case where the ZnO-based semiconductor element is zero-biased; Fig. 3(b) shows a case forward-biased; and Fig. 3(c) shows a case reverse-biased. Also, E_{FO} represents Fermi level of the organic electrode 2; E_{FZ}, Fermi level of the ZnO-based semiconductor 1; VL, vacuum level; ϕ_{O}, a work function of the organic electrode 2; ϕ_{Z}, a work function of the ZnO-based semiconductor 1; Ec, level of a conduction band; Ev, level of a valence band; and X_{Z}, an electron affinity of the ZnO-based semiconductor 1.

When zero-biased as shown in Fig. 3(a), the ZnO-based semiconductor coincides in Fermi level with the organic electrode and hence is balanced therewith, thus developing a barrier (i.e., a built-in potential) ϕ_{O}-ϕ_{Z} against an electron flow from the ZnO-based semiconductor to the organic electrode, and a Schottky barrier ϕ_{O}-X_{Z} against an electron flow from the organic electrode to the ZnO-based semiconductor.

On one hand, when a forward direction bias, which is in a direction canceling out ϕ_{O}-ϕ_{Z}, is applied as shown in Fig. 1, the barrier on the side of the ZnO-based semiconductor is lowered by qV and the barrier on the side of the organic electrode remains unchanged, as shown in Fig. 3(b), thus increasing the electron flow from the ZnO-based semiconductor to the organic electrode. On the other hand, if the direct-current power supply shown in Fig. 1 is connected in reverse direction (that is, a reverse direction bias is applied), the barrier on the side of the ZnO-based semiconductor increases by qV, as opposed to its Fig. 3(b) position, and the barrier on the side of the organic electrode remains unchanged resulting in a such state as shown in Fig. 3(c). Thus, there is little electron flow from the ZnO-based semiconductor to the organic electrode.

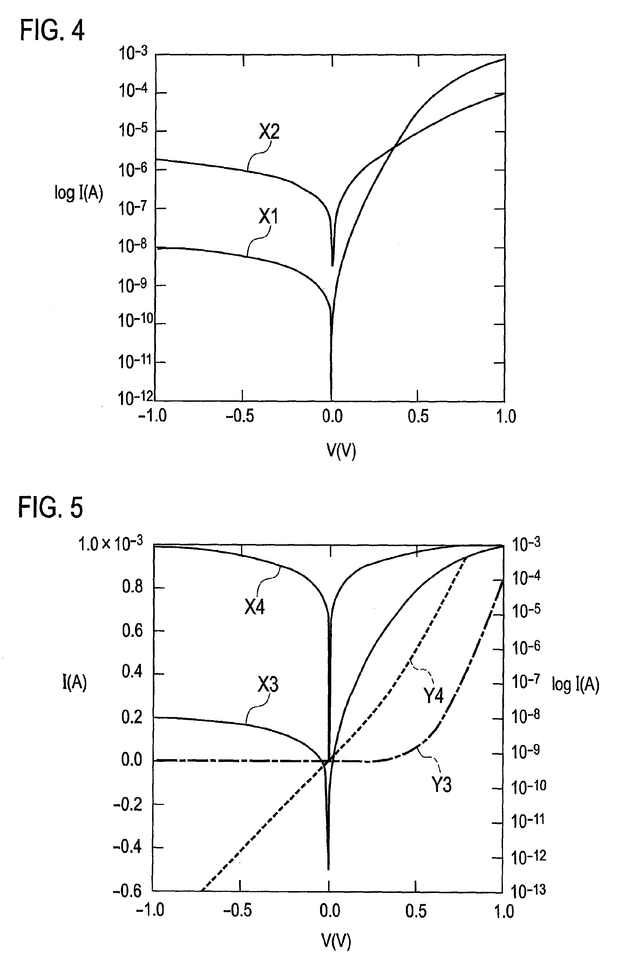

As described above, when the ZnO-based semiconductor 1 and the organic electrode 2 are bonded together in the relationship ϕ_{O} > X_{Z}, rectification as in the case of the pn junction is generated. According to the present invention, as mentioned above, the organic electrode 2 is configured as an electrode to play an active role such as controlling the organic matter-semiconductor interface. Figs. 4 and 5 show an IV characteristic between the ZnO-based semiconductor 1 and the organic electrode 2. X1 of Fig. 4 and X3 of Fig. 5 show the IV characteristic in a case where, having a configuration of Fig. 1, the ZnO-based semiconductor 1 is formed of the n-type ZnO substrate and the organic electrode 2 is formed of the PEDOT/PSS. For comparison, X2 of Fig. 4 and X4 of Fig. 5 show the IV characteristic in ca case where, having a configuration of Fig. 1, the organic electrode 2 is replaced by Pt which is frequently and generally used as a Schottky electrode.

In both of Figs. 4 and 5, with a boundary of a voltage V zero, a positive voltage is a forward direction bias (hereinafter referred to as a forward bias), and a negative voltage is a reverse direction bias (hereinafter referred to as a reverse bias). As can be seen also from Fig. 4, X1 and X2 each show that during the application of the reverse bias, a constant amount of minute current flows, whereas the application of the forward bias sharply increases the current, and thus, both X1 and X2 have rectification characteristics. However, as compared to a Schottky junction of a general metal electrode and the n-type ZnO substrate, X1 according to the configuration of the present invention shows that at the reverse bias voltage, a leakage current is very small, while at the forward bias, the amount of current increases greatly,.

Also, Fig. 5 is obtained by getting measured data such as X1 and X2 of Fig. 4 to plot curves X3 and X4, and changing a scale of these graphs to plot curves Y3 and Y4. Graphs expressed in a scale (shown in a range of 1.0×10⁻³ to -0.6×10⁻³ A) of the vertical axis indicated on the left are Y3 (shown by a dash-dot line) and Y4 (shown by a dotted line), and X3 and X4 converted from the right scale log I to the left linear scale correspond to Y3 and Y4, respectively.

As can be seen from Fig. 5, the graph of Y4 showing the Schottky junction of the general metal electrode and the n-type ZnO substrate shows that during a time period from reverse bias application and to forward bias application, the amount of current flowing increases in both positive and negative directions, whereas the graph of Y3 according to the configuration of the present invention shows that at the reverse bias, almost no current flows, while at the forward bias, the current increases as an applied voltage increases, and thus, Y3 exhibits the rectification characteristics.

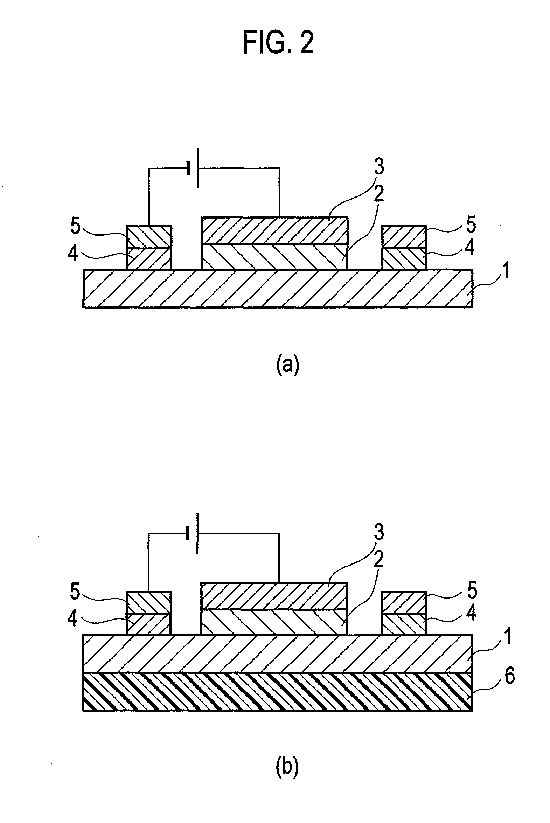

Then, Fig. 2 shows a structure that has basically the same configuration as shown in Fig. 1 but is different particularly in configuration of a negative electrode. The same reference numerals as shown in Fig. 1 denote the same structural components. In Fig. 2(a), the negative electrode is not formed on the back surface of the ZnO-based semiconductor 1, but a positive electrode and the negative electrode are formed on one and the same side of the ZnO-based semiconductor 1, and the negative electrode is formed annularly so as to surround the periphery of a laminate formed of the organic electrode 2 and the Au film 3. Also, Fig. 2(b) shows a configuration in which a substrate 6 serving as a supporting substrate is attached to the structure shown in Fig. 2(a).

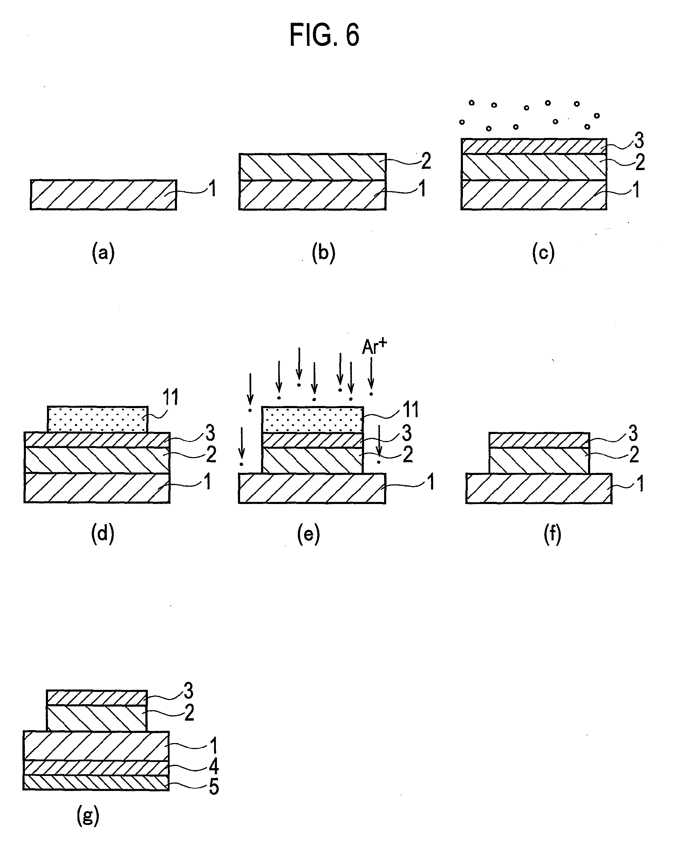

Fig. 6 shows an example of a manufacturing process for the ZnO-based semiconductor element shown in Fig. 1 which employs the n-type ZnO substrate for the ZnO-based semiconductor 1, and the PEDOT/PSS for the organic electrode 2. First, the n-type ZnO substrate is heat treated at a temperature around 1100°C, is subjected to ultrasonic cleaning in an acetone or ethanol solution, and is subsequently irradiated with ultraviolet-ozone as a hydrophilic treatment (See Fig. 6(a)). Then, as shown in Fig. 6(b), the PEDOT/PSS is applied and formed on the n-type ZnO substrate by spin coating and is baked at a temperature around 200°C. After that, an Au metal is vapor deposited to form the Au film 3 as shown in Fig. 6(c), then, a resist 11 is formed as shown in Fig. 6(d), and a mesa structure is formed by dry etching using Ar⁺ plasma or the like as shown in Fig. 6(e). The resist is removed by ultrasonic cleaning in an acetone solution (see Fig. 6(f)), and subsequently, a Ti metal is vapor deposited to form the Ti film 4, and further, an Au metal is vapor deposited to form the Au film 5. Thereby, the ZnO-based semiconductor element shown in Fig. 1 is completed.

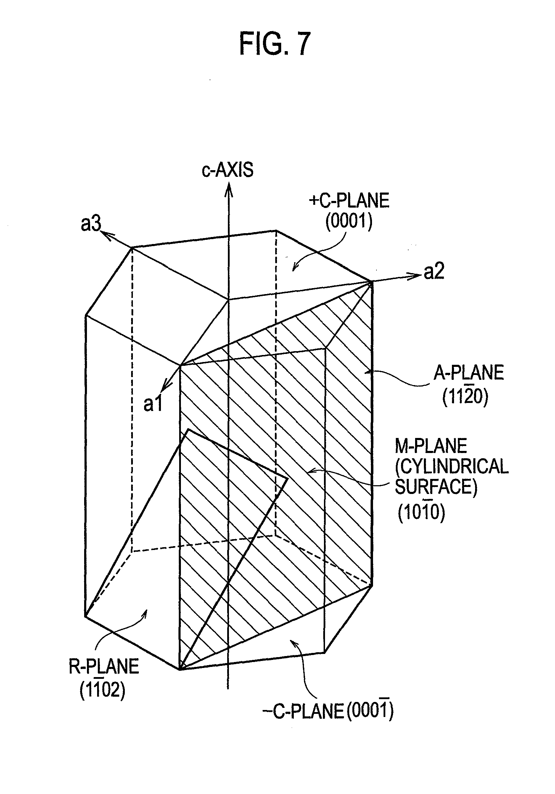

Incidentally, the ZnO-based semiconductor has a hexagonal crystal structure called "wurtzite," as is the case with GaN. The expressions "C-plane" and "a-axis" can be expressed by what is known as Miller indices, and for example, the C-plane is represented as a (0001) plane. Fig. 7 shows a schematic structural diagram of a ZnO-based semiconductor crystal, in which a shaded plane is an A-plane (11-20), and an M-plane (10-10) is a cylindrical surface of the hexagonal crystal structure. For example, a {11-20} plane or a {10-10} plane is a generic name including a plane equivalent to the (11-20) plane or the (10-10) plane, because of symmetry of the crystal. Also, the a-axis represents al, a2 and a3 in Fig. 7 and shows a vertical direction of the A-plane, an m-axis shows a vertical direction of the M-plane, and a c-axis indicates a vertical direction of the C-plane.

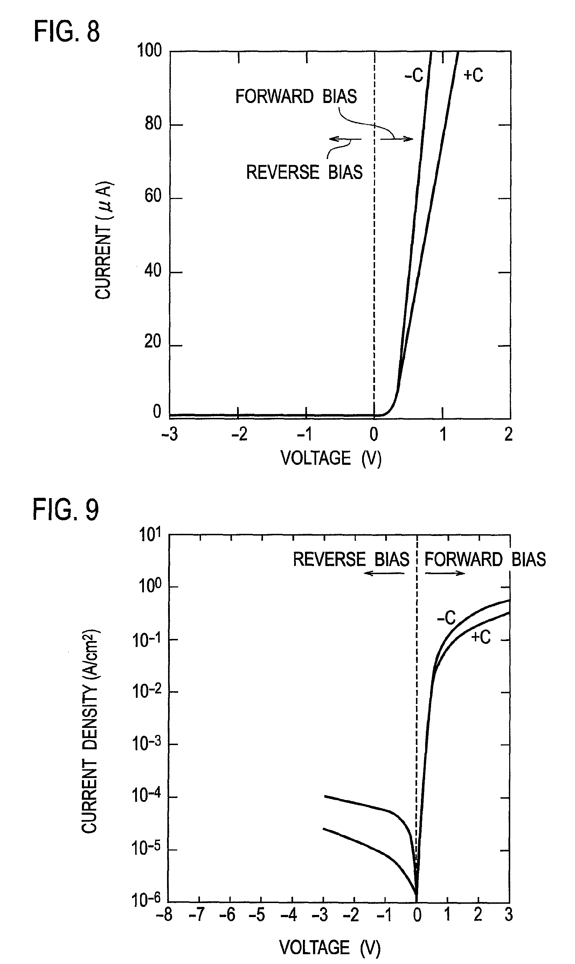

When the organic electrode 2 is to be formed on the ZnO-based semiconductor 1, it is important to select which crystal plane of the ZnO-based semiconductor 1 is selected on which the organic electrode 2 is formed, because the characteristics of the element depends on the selection of the crystal plane. Firstly, the element has difference stabilities between when having the organic electrode 2 formed in a +C-plane of the ZnO-based semiconductor 1 and when having the organic electrode 2 formed in a -C-plane thereof. Fig. 8 shows a comparison of voltage-current characteristics of the configuration shown in Fig. 1 between when the organic electrode 2 is formed on the +C-plane of the ZnO-based semiconductor 1 and when the organic electrode 2 is formed on the -C-plane thereof. Also in these cases, the n-type ZnO substrate is used for the ZnO-based semiconductor 1, and the PEDOT/PSS is used for the organic electrode 2. As shown in Figs. 8 and 9, the current-voltage characteristics in these cases are about the same.

However, the -C-plane of the ZnO-based semiconductor is more sensitive to acid or alkali than the +C-plane is and thus the processing thereof is difficult. In particular when the PEDOT/PSS is used for the organic electrode 2, it exhibits acidity around pH 2 to 3 as can be seen also from a structural formula in Fig. 14, and thus, the -C-plane shows a phenomenon in which the characteristics of the element become unstable with slight etching. It is therefore desirable that the organic electrode 2 be formed on the +C plane.

As mentioned above, it has been shown that the +C plane is satisfactory for a principal surface of the ZnO-based semiconductor 1 that forms the organic electrode 2; however, actually, as far as being cut from a bulk, the +C plane just substrate cannot be stably fabricated. Thus, used is the ZnO-based semiconductor 1 which has a principal surface in which a normal to the principal surface of the semiconductor or a normal to the principal surface of the substrate is inclined from the c-xis at least in the direction of the m-axis is used.

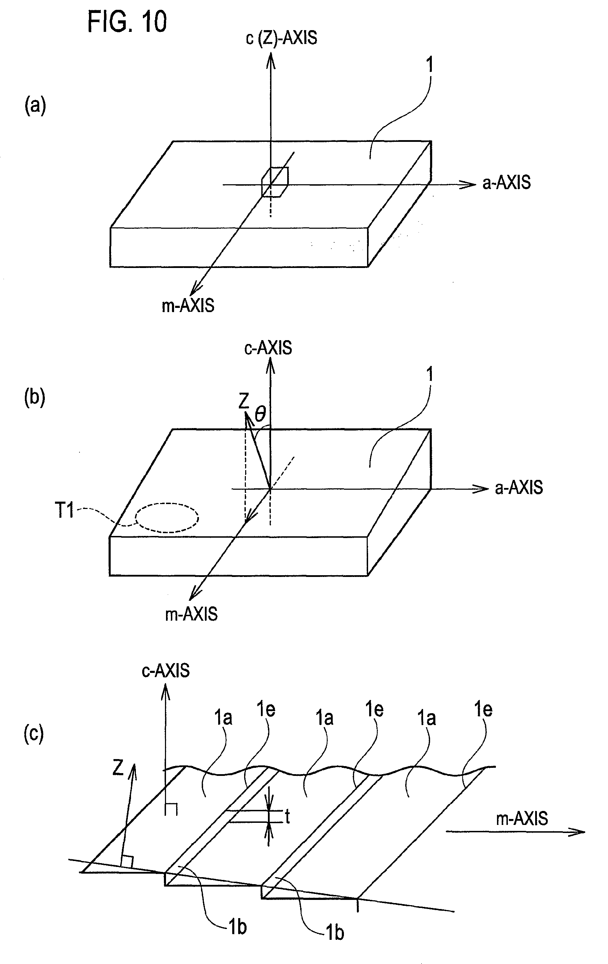

To grow the ZnO-based thin film on the ZnO-based material layer, typically, the C plane, or (0001)-plane is used; however, when the C plane just substrate is used, as shown in Fig. 10(a), the direction of a normal to the principal surface of the wafer coincides with the direction of the c-axis. However, in a bulk crystal, the direction Z of the normal does not coincide with the direction of the c-axis as shown in Fig. 10(a), unless the cleavage plane of the crystal is used, and productivity decreases if the C-plane just substrate is considered necessary. Also, it is known that flatness of the film is not improved even if the ZnO-based thin film is grown on the C plane just ZnO-based substrate.

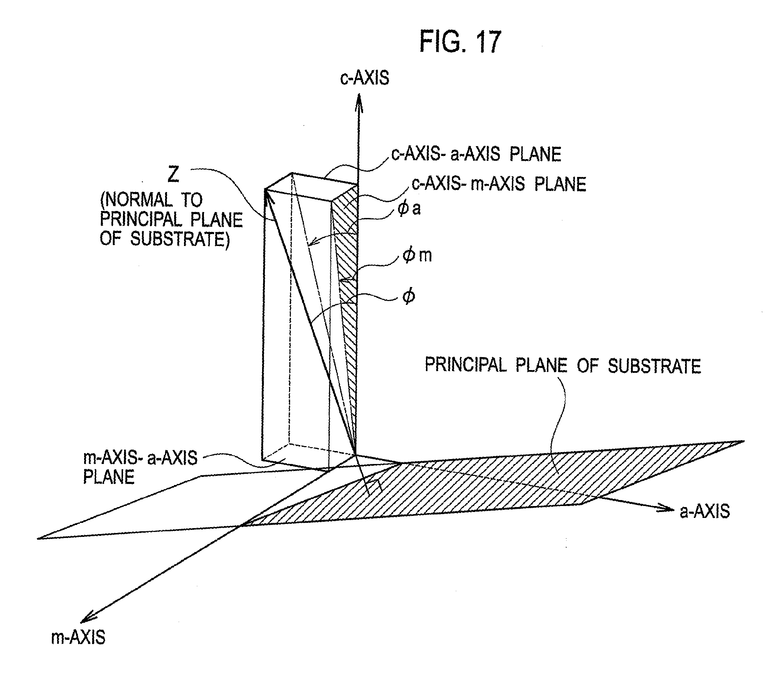

Fig. 17 shows a case where: the normal Z to the principal surface of the substrate is inclined by an angle Φ from the c-axis of the crystal axis of the substrate; and a projection (projection) axis obtained by projecting (projecting) the normal Z onto a plane of the c-axis and the m-axis in rectangular coordinate systems of the c-axis the m-axis and the a-axis of the crystal axis of the substrate is inclined by an angle Φₘ toward the m-axis and a projection axis projected in a plane of the c-axis and the projection axis obtained by projecting the normal Z onto a plane of the c-axis and the a-axis is inclined by an angle Φₐ toward the a-axis In other words, the direction of the normal to the principal surface of the ZnO-based semiconductor 1 (or the wafer) does not coincide with the direction of the c-axis and the normal Z to the principal surface of the substrate is inclined from the c-axis of the crystal axis of the substrate so that an off angle is obtained.

For example, as shown in Fig. 10(b), if the normal Z to the principal surface is present in the plane of the c-axis and the m-axis and the normal Z is inclined from the c-axis only toward the m-axis by θ degree, a terrace surface 1a and a step surface 1b are formed as shown in Fig. 10(c) showing an enlarged view of a surface portion (e.g., a T1 region) of the substrate 1. Here, the terrace surface 1a is a flat surface, and the step surface 1b is located in a stepped portion produced by the inclination of the normal Z and is arranged regularly at equal intervals.

Here, the terrace surface 1a forms the C-plane (0001), and the step surface 1b corresponds to the M-plane (10-10). As shown in the drawing, the formed step surfaces 1b are regularly arranged while keeping the width of the terrace surface 1a in the direction of the m-axis. In other words, the c-axis perpendicular to the terrace surface 1a and the normal Z to the principal surface of the substrate form an off angle of θ degree. Also, step lines 1e each forming a step edge of the step surfaces 1b are arranged in parallel to each other while keeping the vertical relation to the direction of the m-axis and keeping the width of the terrace surface 1a.

As mentioned above, when the step surface is a surface corresponding to the M-plane the ZnO-based semiconductor layer obtained by crystal growth on the principal surface can be a flat film. On the principal surface, the step portions are formed by the step surfaces 1b; however, atoms landing on the step portion form a bond between two surfaces, i.e., the terrace surface 1a and the step surface 1b, and thus, the atoms can be more firmly bonded, than a case where they land on the terrace surface 1a, so that the flying atoms can be securely trapped.

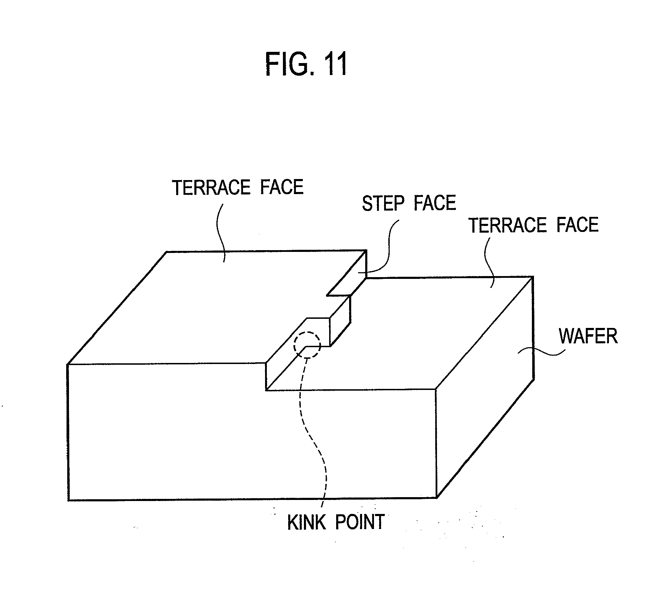

In the process of surface diffusion, the flying atoms diffuse into the terrace. Here, stable growth is performed by lateral growth in which the crystal growth proceeds while the atoms are trapped by the step portion having high bond strength and by a kink position (see Fig. 11) formed at the step portion to be incorporated into the crystal. At this time, it is desirable that the step surface 1b be thermally stable, and for this reason the M-plane is excellent. As mentioned above, when the ZnO-based semiconductor layer is deposited on the substrate in which the C-plane is inclined at least in the direction of the m-axis the ZnO-based semiconductor layer can be a flat film with the crystal growth occurring centered at the step surface 1b.

In other words, the regular arrangement of the step edges in the direction of the m-axis is required for fabrication of the flat film. If the interval between the step edges or alignment between the step edges becomes irregular, the above-mentioned lateral growth does not occur, and thus, the flat film cannot be fabricated. Therefore, as a condition to form the flat film, the normal to the principal surface of the thin film or the normal to the principal surface of the substrate has to have the off angle from the c-axis in the direction of the m-axis. However, in Fig. 10(b), if the angle θ of inclination is too large, the step of the step surface 1b becomes too large to allow the flat crystal growth to occur. Therefore, it is desirable that the angle of inclination be 5° or less.

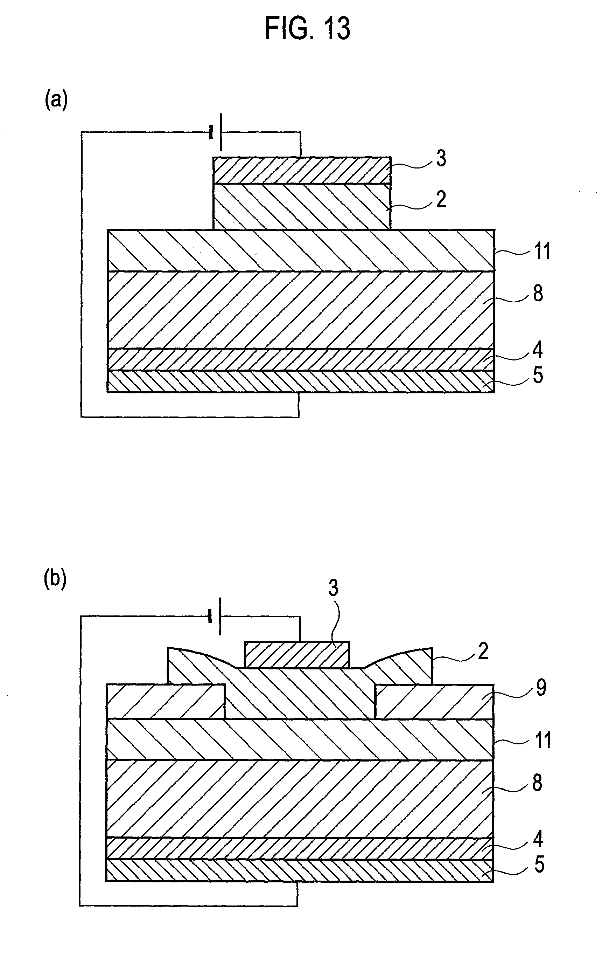

As mentioned above, the formation of the flat ZnO-based semiconductor film on the ZnO-based semiconductor layer is effective in crystal growth of a p-type MgZnO layer 9 on an n-type MgZnO layer 11 serving as the ZnO-based semiconductor, as shown for example in Fig. 13(b). If the principal surface of the ZnO-based semiconductor layer does not have a step structure as mentioned above, the flatness of the organic electrode 2 formed thereon may be affected and element characteristics may also be affected.

The ZnO-based compound is a piezoelectric material. Thus, if a hetero junction such as a stack of a sapphire substrate and the ZnO layer or a stack of the ZnO layer and the MgZnO-based compound layer is formed, distortion occurs based on a difference in lattice constant between the substrate and the ZnO-based compound layer or between the stacked semiconductor layers, and a piezoelectric field (i.e., an electric field produced by stress) is produced based on the distortion. This is because the crystal of the hexagonal crystal system such as ZnO has a wurtzite structure in which there is no symmetry in the direction of the c-axis and an epitaxial film grown on the C-plane has a top and a bottom. The piezoelectric field forms a newly added potential barrier to a carrier, and a drive voltage is increased by increasing a built-in voltage of the diode or the like.

Therefore, in the configuration shown in Fig. 13(a), it is conceivable that the piezoelectric field is produced between the ZnO substrate 8 and the n-type MgZnO layer 11 and thus the drive voltage of the element rises. Also, in the configuration shown in Fig. 13(b), the piezoelectric field is produced between the n-type MgZnO layer 11 and the p-type MgZnO layer 9.

To eliminate the influence of the above-mentioned piezoelectric field, the ZnO-based compound semiconductor layer may be formed or stacked so that a surface on which electric charge is produced by interfacial stress is parallel to the direction of the electric field applied to the element (or so that the piezoelectric field is perpendicular to the electric field applied to the element), and thereby, a problem involved in the piezoelectric field can be solved.

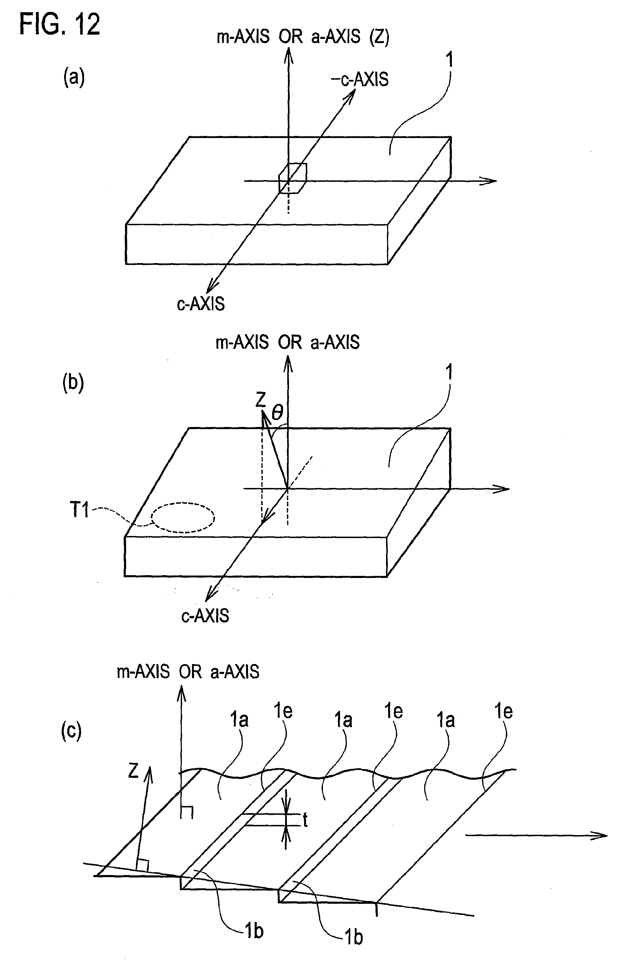

To solve the problem involved in the piezoelectric field, the ZnO-based semiconductor 1 is formed for example of a MgₓZn₁₋ₓO (e.g., ZnO where x=0) substrate or the like, and as shown in Fig. 12(b), and the ZnO-based semiconductor 1 is polished so that the principal plane is inclined in the direction of the axis -c with respect to the A-plane or the M-plane (or with respect to the direction of the normal to the organic electrode 2). The angle θ of inclination lies between about 0.1° and 10°, or more preferably between about 0.3° and 5°.

Fig. 12(a) shows a schematic view of the ZnO-based semiconductor 1 in which the principal plane of the thin film or the substrate coincides with the A-plane or the M-plane and the normal to the principal plane coincides with the m-axis or the a-axis As mentioned above, using such a semiconductor can have a configuration such that the surface on which the electric charge is produced by the interfacial stress, namely, the +C-plane, is parallel to the direction of the electric field applied to the element (or such that the piezoelectric field is perpendicular to the electric field applied to the element), thus enables solving the problem of the piezoelectric field, and thus enables preventing a rise in the drive voltage.

However, even if the A-plane or M-plane just substrate is supposed to be formed as shown in Fig. 12(a), a completely flat surface cannot be actually formed, and thus the normal Z to the principal plane of the substrate is inclined at least in the direction of the c-axis with respect to the m-axis or the a-axis as shown in Fig. 12(b). As shown in Fig. 12(c) showing an enlarged view of the substrate surface portion T1 shown in Fig. 12(b), the normal to the principal plane of the substrate is inclined in the direction of the c-axis with respect to the m-axis or the a-axis and thereby, the terrace plane 1a and the step plane 1b located in the step portion formed by the inclination and regularly arranged at equal intervals are formed on the principal plane. Since the step plane 1b formed by the step on the surface and the other terrace plane 1a are formed, and the step plane coincides with the direction of the +c-axis, the carrier density of the p-type layer can be improved.

Also, the direction of inclination coincides with the direction of the -c-axis, and thereby, in the step plane 1b, the +C-plane oriented in the direction of the +c-axis is exposed at all times. The crystal growth occurring in such a state causes the lateral growth, and a stable growth so that the flat film can be formed for the same reason as described with reference to Fig. 10.

Fig. 13 shows a modified example of the basic structure shown in Fig. 1. The same reference numerals as shown in Fig. 1 denote the same structural components. Fig. 13(a) shows a case where the n-type MgₓZn₁₋ₓO (where 0 ≤ x ≤ 0.5) layer 11 formed on the n-type ZnO substrate 8 is used as the ZnO-based semiconductor being in contact with the organic electrode 2 and the doping density is changed. A manufacturing method thereof will be described below.

The n-type ZnO substrate 8 is processed by a dilute hydrochloric acid, is heated, and subsequently, causes the n-type MgZnO layer 11 having a carrier density of the 17th power or less to grow thereon. Mg is added in order to expand a band gap. MBE (molecular beam epitaxy) was used as a thin film formation method for the n-type MgZnO layer 11. Besides the MBE, CVD (chemical vapor deposition), MOCVD (metal organic chemical vapor deposition), PLD (pulse laser deposition), or the like is also applicable.

The +C-plane of the n-type ZnO substrate 8 was used for the growth substrate. Besides, an oxygen polarity plane or the M-plane of the ZnO substrate may be used. Besides the ZnO substrate, a sapphire substrate (the C-plane, the A-plane or the R-plane), an ScAlMgO₄ substrate, or the like may be used; however, for fabrication of ZnO having good crystallinity, ZnO or ScAlMgO₄ is desirable. The growth substrate is held at 250°C for 20 minutes in a preheating chamber. Then, the growth substrate is transported into a growth chamber, is heated to 800°C, and is subsequently kept at a growth temperature. The growth temperature lies between 300 and 1000°C. Zn (with a purity of 99.99999%) and an oxygen gas (with a purity of 99.99999%) were used as a main material. A nitrogen gas was used as a material for a p-type dopant. Besides, ozone (O₃), nitrogen dioxide (NO₂), nitrous oxide (N₂O) nitrogen monoxide (NO), or the like is suitable for the gas for use as the material.

Zn is heated to 250 to 350°C in a K-cell crucible and is fed to the surface of the growth substrate. When Mg is used, Mg is heated to 300 to 400°C in the K-cell crucible and is fed to the surface of the growth substrate, as in the case of Zn. The oxygen gas passes through radical cells to the surface of the growth substrate. In the radical cells, a high frequency is applied to the gas, and the gas changes into a plasma state and a highly-chemically activated state. A high frequency of 13.56 MHz and an output of 300 to 400 W were applied; however, a frequency of 2.4 GHz or an output of 50W to 2 kW may be applied besides these. A flow rate of the oxygen gas was set to 0.3 to 3 sccm, and a flow rate of the nitrogen gas was set to 0.2 to 1 sccm. Thereafter, the layers are formed in the same manner as the manufacturing method shown in Fig. 6.

Next, Fig. 13(b) shows the structure where, in the structure shown in Fig. 13(a), the p-type MgZnO layer 9 is formed so as to be in contact with the n-type MgZnO layer 11, and thereby, the structure of the organic electrode 2 is modified a little to reduce the leakage current. A manufacturing method for the MgZnO layer is the same as shown in Fig. 13(a), and an opening is formed by etching after the p-type MgZnO layer 9 is deposited. Thereafter, the same process as shown in Fig. 6 is used for fabrication except that the organic electrode 2 lies over a portion of the p-type MgZnO layer 9. This enhances reduction in leakage. Incidentally, for formation of p-type ZnO such as the p-type MgZnO layer 9, the +C-plane is desirable. Incidentally, even with the -C-plane, the method disclosed in Non-patent Document 2 may be used for fabrication.

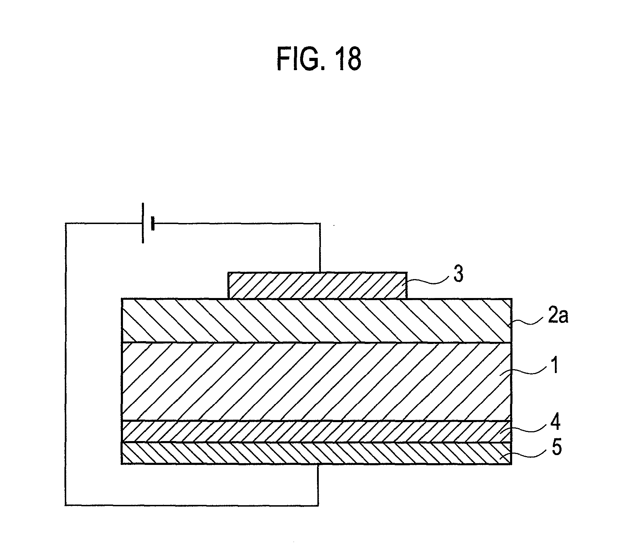

A photodiode may be formed as an example of the ZnO-based semiconductor element described above. The photodiode in which the organic electrode 2 has translucency in an ultraviolet region is used. Here, the phrase "having translucency in an ultraviolet region" means that when irradiated with light, the organic electrode 2 has a transmittance of 70% or more in the wavelength range of light of 400 nm or less. Specifically, using an organic electrode 2a formed of the PEDOT/PSS and having a thickness of 50 nm, the ZnO-based semiconductor element shown in Fig. 18 is fabricated. The ZnO substrate is used for the ZnO-based semiconductor 1, the PEDOT/PSS is formed on the ZnO substrate, the Au film 3 is formed on the PEDOT/PSS, and the Ti film 4 and the Au film 5 are formed in order on the back surface of the ZnO substrate. A configuration shown in Fig. 18 is substantially the same as that shown in Fig. 1, however, the organic electrode 2a is laminated across the overall surface of the ZnO-based semiconductor 1 in order to increase a photoreceptive area. Also, in Fig. 18, the direct-current power supply is reversed to apply a reverse bias, unlike Fig. 1.

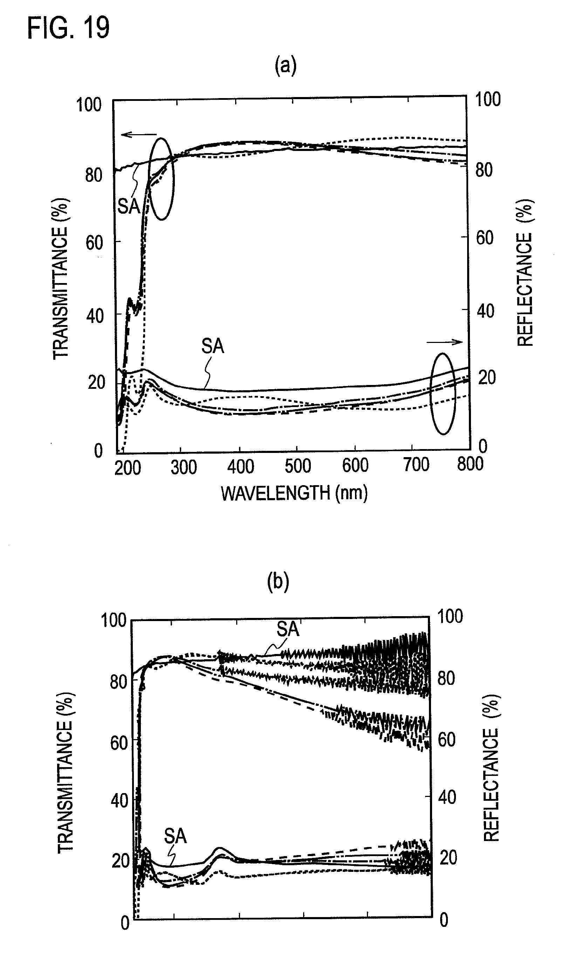

The PEDOT/PSS used for the organic electrode 2a has properties as shown in Fig. 19. Fig. 19(a) shows a comparison of light transmittance and reflectance of the sapphire substrate made of the oxide and light transmittance and reflectance of the PEDOT/PSS. Likewise, Fig. 19(b) shows the transmittance and the reflectance in the range of wavelengths of 0 to 2500 nm. In other words, Fig. 19(a) is an enlarged view of the range of 0 to 800 nm of the wavelength range shown in Fig. 19(b).

The horizontal axis indicates the wavelength of light, the left vertical axis indicates the light transmittance, and the right vertical axis indicates the light reflectance. Also, a curve drawn in the upper part of the graph represents a transmittance curve, and a curve drawn in the lower part represents a reflectance curve. SA indicates the sapphire substrate, and other curves represent the curves of the PEDOT/PSS. As described above, the PEDOT/PSS exhibits a transmittance of 80% or more in the range of wavelengths of 400 nm or less, or particularly wavelengths of 300 to 400 nm, and it is thus found that the PEDOT/PSS is excellent in transmittance. On the other hand, in the range of wavelengths of 300 to 400 nm, the reflectance is 20% or less.

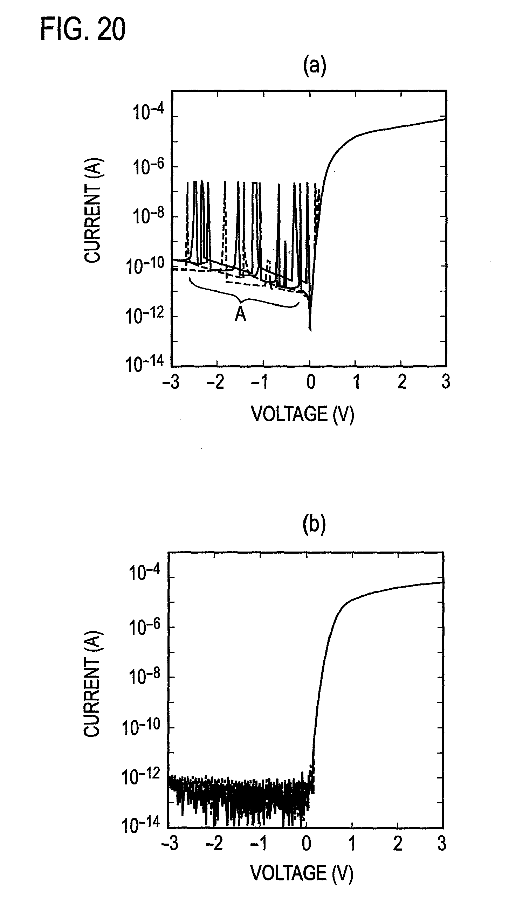

Then, Fig. 20(a) is a graph of a preliminary experiment, showing a voltage (bias) vs. current (optical current) characteristic obtained when light is applied in a pulse manner on the ZnO-based semiconductor element having the configuration shown in Fig. 18, while the current-voltage measurement of the ZnO-based semiconductor element is being made. The vertical axis represents the absolute value of the optical current flowing through the ZnO-based semiconductor element, and the horizontal axis represents the voltage applied to the ZnO-based semiconductor element. Also, a region A indicates a change in the current, which occurs when the light is applied in a pulse manner. On the other hand, Fig. 20(b) shows a dark current characteristic under no light irradiation. As shown in Figs. 20(a) and 20(b), with the boundary of zero volts, a positive voltage represents a forward bias, and a negative voltage represents a reverse bias. As can be seen from these graphs, at the reverse bias voltage, the leakage current is very small, and the element can react even with feeble light. Also, it is found that at the reverse bias, the current flows according to the intensity of the light applied.

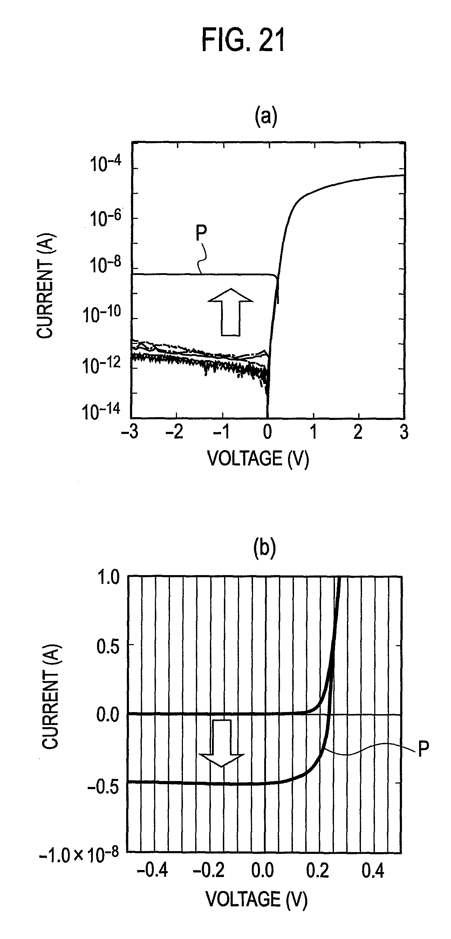

Also, Fig. 21 shows a voltage (bias) vs. current (optical current) characteristic when light is applied continuously not in a pulse manner. The vertical axis of Fig. 21(a) represents the absolute value of the current flowing through the ZnO-based semiconductor element shown in Fig. 18, and the horizontal axis thereof represents the voltage applied to the ZnO-based semiconductor element. As can be seen from Fig. 21(a), a characteristic curve P obtained after the light irradiation shows that, the current increases particularly from the vicinity of a zero bias to -1 V. Fig. 21(b) shows in enlarged part of Fig. 21(a) which shows the range of bias voltages from -0.5 to +0.5 V, however, it is to be noted that the vertical axis indicates the value having the polarity of the optical current, not the absolute value. As can be seen clearly from Fig. 21(b), the current value of the characteristic curve P when the light is applied increases by about 0.5×10⁻⁸ A in the negative direction, as compared to the characteristic curve under no light irradiation.

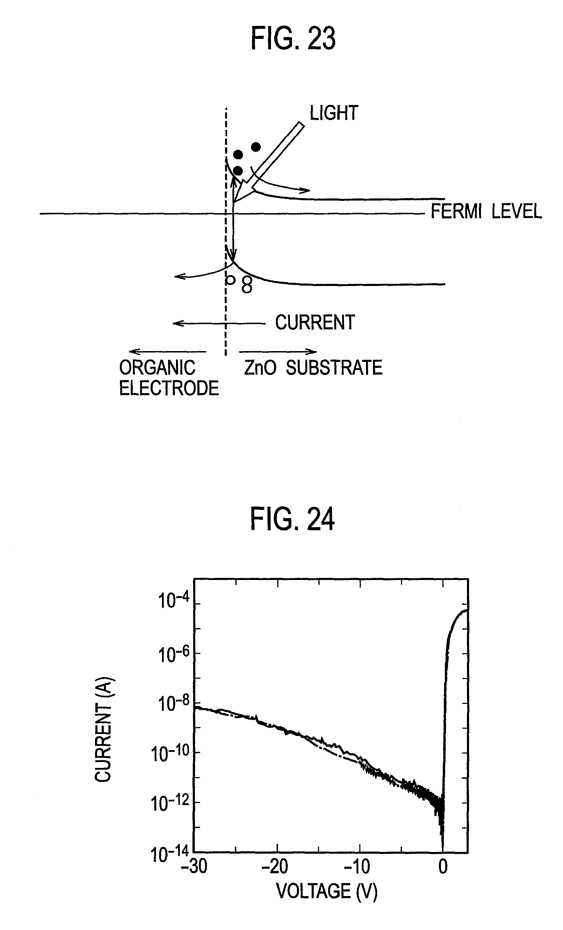

Fig. 23 shows a state at this time around the interface between the organic electrode 2 and the ZnO substrate (or the ZnO-based semiconductor 1). When the reverse bias is applied, a Schottky barrier appears since the organic electrode 2 and the ZnO substrate form a Schottky junction and a depletion layer extends at the interface between the organic electrode 2 and the ZnO substrate. When light is applied on the vicinity of the depletion layer, electrons are excited to move to the conduction band as shown in the drawing, and a hole remains in the valence band. The electrons are accelerated in the conduction band and flow toward lower energy level (or in the direction of positive polarity), and the hole flows in the opposite direction (or in the direction of negative polarity), as shown by the arrows in the drawing. Thus, the flow of the optical current is the reverse current flowing from the positive polarity to the negative polarity at the reverse bias. In other words, the organic electrode 2 serves as a hole conductor.

Incidentally, Fig. 24 shows data on the voltage-current characteristic under no light irradiation. It is found that even at a reverse bias voltage around -30 V, the current is extremely feeble, and a withstand voltage in a reverse bias direction is sufficient.

Also, a study disclosed in "M. Nakano et al., Applied Physics Letters 91, 142113 (2007) "Schottky contact on a ZnO (0001) single crystal with conductive polymer"" has shown that a contact interface between the ZnO and the PEDOT/PSS forms a Schottky junction.

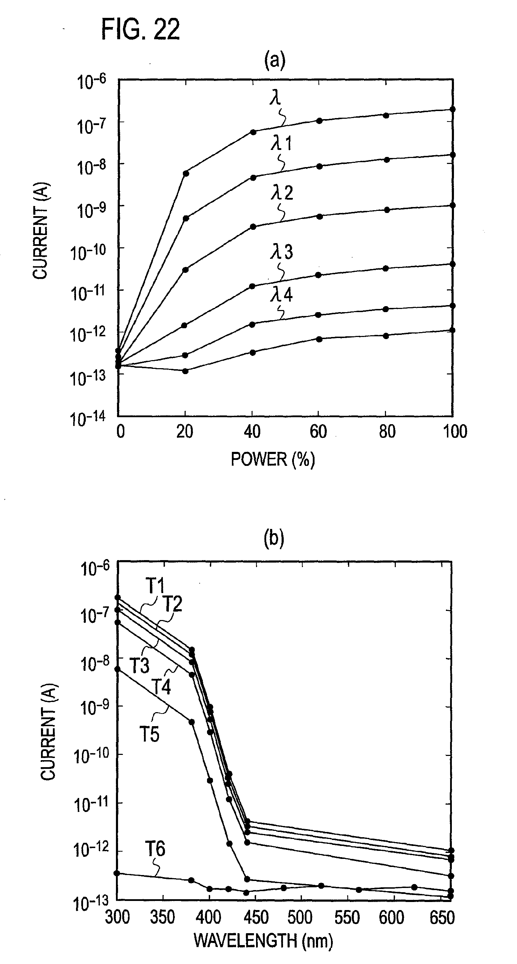

Fig. 22 shows results obtained when light is applied to the ZnO-based semiconductor element shown in Fig. 18 not directly but through a filter. A frequency high-pass filter is used as the filter. In other words, by use of the filter that allows short wavelength components, in wavelength term, of light to pass through, the reverse current flowing during light irradiation is measured.

In Fig. 22(a), the vertical axis indicates the absolute value of the reverse current (or the optical current), and the transmittance of the filter is indicated by the horizontal direction. Also, λ indicates a curve obtained when light is applied directly without using the filter; λ1 indicates a curve obtained by using a filter that allows wavelengths satisfying λX>380 nm to pass therethrough; λ2 indicates a curve obtained by using a filter that allows wavelengths satisfying λX>400 nm to pass therethrough; λ3 indicates a curve obtained by using a filter that allows wavelengths satisfying λX>420 nm to pass therethrough; and λ4 indicates a curve obtained by using a filter that allows wavelengths satisfying λX>440 nm to pass therethrough, where λX denotes the wavelength of the light.

As shown above, the current value lowers as excluded wavelength components of the light becomes shorter. Detectivity gets closer to λ with a no-filter condition, as wavelength components of 400 nm or less are included. On the other hand, Fig. 22(b) is created based on Fig. 22(a) by plotting the current values for λ and λ1 to λ4 for given transmittance of the filter on the horizontal axis. For example, there are 5 current values of a transmittance of 100% in Fig. 22(a) for λ and λ1 to λ4. These current values are shown as T1 while the horizontal axis indicates the threshold of transmission wavelength of the filters of λ and λ1 to λ4 (unit: nm), and the vertical axis indicates the current value. Likewise, T2 is obtained by plotting values of a transmittance of 80% on the horizontal axis of Fig. 22(a); T3 is obtained by plotting values of a transmittance of 60%; T4 is obtained by plotting values of a transmittance of 40%; T5 is obtained by plotting values of a transmittance of 20%; and T6 is obtained by plotting values of a transmittance of 0%.

As is apparent from Fig. 22(b), the current value rises sharply as light is applied to the ZnO-based semiconductor element through the region of shorter wavelengths, and thus it is found that this is an optimum configuration particularly for highly sensitive detection of light in an ultraviolet region, that is, wavelength components of 400 nm or less.

Description will now be given below of an example where the above-mentioned ZnO-based semiconductor element is applied to a HEMT (high electron mobility transistor). It is known that a two-dimensional electron gas is generated at an MgZnO-ZnO interface, and we have found out that the electron mobility of the gas has a value exceeding 15000 cm²V⁻¹s⁻¹ at an absolute temperature of 0.5 K. This value is comparable to that of the two-dimensional electron gas at an AlGaN-GaN interface typically fabricated. Thus, even using the ZnO-based semiconductor, it is sufficient enough to form the equivalence of a HEMT of a high withstand voltage type, which is actively studied using GaN.

The ZnO has an electron affinity about 4.2 V, which is deeper than Si and almost all of Group III-V semiconductors do. The work function of metal congregates at the vicinity of approximately 4 to 5 eV, which is substantially the same as the conduction band minimum (CBM) of the ZnO. Thus, the ZnO has difficulty in coming into Schottky contact with the metal and slightly comes into Schottky contact therewith when having very low the donor concentration ND. However, using the PEDOT/PSS or the like of the organic matters enables ZnO to come into Schottky contact therewith even having the donor concentration ND on the order of the 17th power. Therefore, the HEMT can be configured by using the organic electrode as a gate electrode for the ZnO-based semiconductor and using the two-dimensional electron gas generated by a laminated structure of Mg_{X}ZnO (where 0 ≤ X < 1) and Mg_{Y}ZnO (where 0 < Y < 1) for the ZnO-based semiconductor.

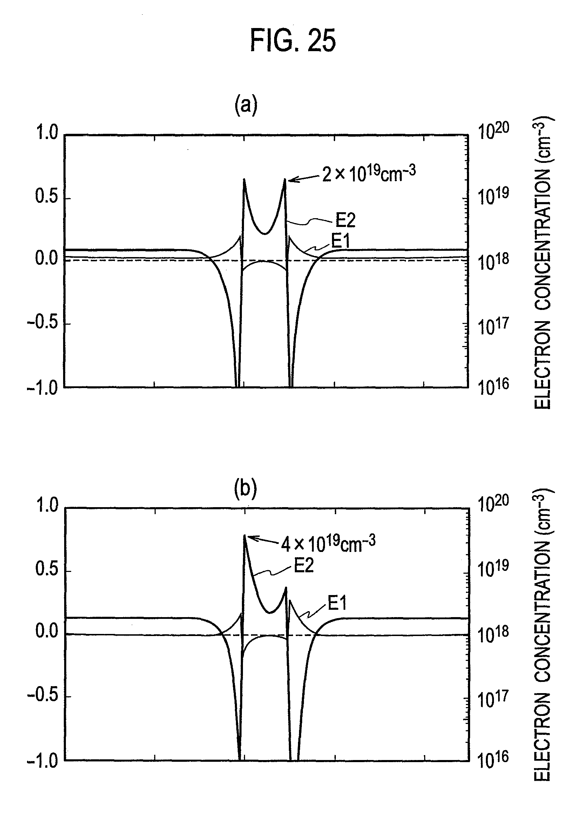

Firstly, Fig. 25 shows a piezoelectric effect developed in a laminated structure of ZnO/MgZnO/ZnO. A dotted line indicates the Fermi level; E1 indicates the conduction band minimum (CBM) of the conduction band; and E2 indicates electron concentration. Shown is band profile simulation in a case where the MgZnO having an Mg composition proportion of 20% and a donor concentration ND of 2×10¹⁸ cm⁻³ is used and sandwiched between the ZnO layers each having 10 nm in thickness and a donor concentration ND of 1×10¹⁷ cm⁻³ to form the laminated structure. This value of the donor concentration of the ZnO is the typical value produced by an unintentional impurity or intrinsic defect (such as interstitial Zn) even without intentional doping. Two peaks appear symmetrically as shown in Fig. 25(a), whereas in Fig. 25(b), one of the peaks is very high and the piezoelectric effect is exhibited.

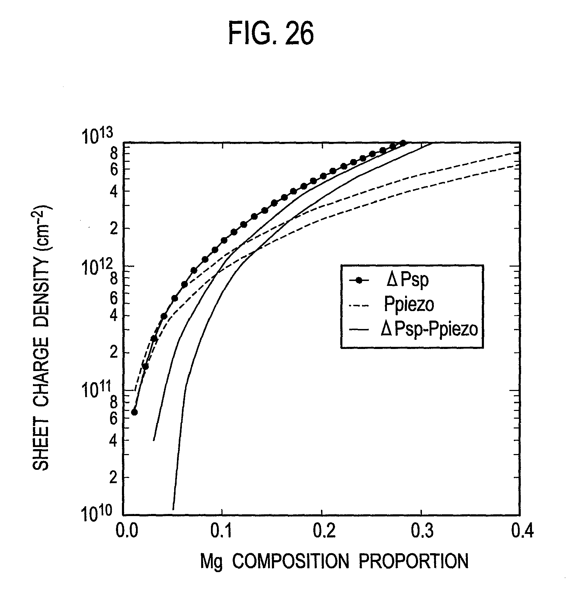

Fig. 26 shows the relationship between sheet charge density and Mg composition proportion of the MgZnO at the MgZnO-ZnO bonding interface. The horizontal axis represents the Mg composition proportion, and the vertical axis represents the sheet charge density. In Fig. 26, a curve of Δ Psp (i.e., the curve connecting dots (•)) shows a curve derived from a spontaneous polarization difference, and curves of Ppiezo (i.e., the curve shown by a dotted line) show curves derived from piezoelectric polarization induced by the piezoelectric effect. Also, each curves of Δ Psp-Ppiezo (i.e., the curve shown by a full line) shows a difference between the above-mentioned spontaneous polarization and corresponding one of the two curves on piezoelectric polarization. At a point where vertical relationship between the curve of Δ Psp and the curve of Ppiezo is reversed, the Mg composition proportion has a value around 0.05 (5%). We cannot say for sure since the value of piezoelectric field tensor of the ZnO varies, but it is conceivable that the sign of Δ Psp-Ppiezo is reversed around 5%. Thus, if some different phenomenon is to occur, the border should be around 5% of an Mg composition proportion.

At the MgZnO-ZnO bonding interface, the piezoelectric polarization, if subjected to compressive strain, acts in a direction canceling out the spontaneous polarization. However, considering the description of Fig. 26, unless using MgZnO having the Mg composition proportion about 5% or less, the spontaneous polarization varies more largely, and piezoelectric polarization large enough to cancel out the spontaneous polarization difference does not occur. Therefore, in almost all cases, a two-dimensional electron gas region (or an electron storage layer) is formed at the MgZnO-ZnO interface.

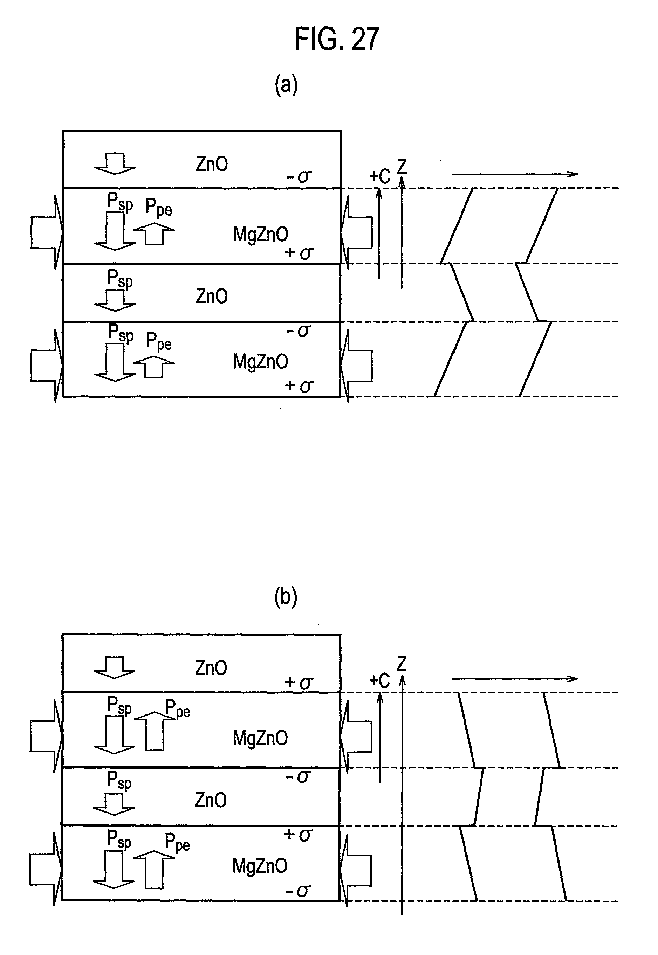

Fig. 27(a) is an illustration showing the direction and magnitude of the polarization difference, which are observed when the MgZnO having the Mg composition proportion of a large value exceeding about 5% is used to form the ZnO/MgZnO/ZnO/MgZnO laminated structure grown on the +C-plane, and the compressive strain is applied thereon from a transverse direction. Psp represents the spontaneous polarization; Ppe represents the piezoelectric polarization; and σ represents the charge density at the hetero interface. On the other hand, Fig. 27(b) is an illustration showing the direction and magnitude of the polarization difference, which are observed when the MgZnO having the Mg composition proportion of a small value of about 5% or less is used to form the ZnO/MgZnO/ZnO/MgZnO laminated structure grown on the +C-plane, and the compressive strain is applied thereon from the transverse direction. Incidentally, out of bent lines drawn on the right side of the laminate in each of Figs. 27(a) and Fig. 27(b), the left bent line indicates the magnitude of the polarization difference in the absence of crystal strain, and the right bent line indicates the magnitude of the polarization difference when the compressive strain is applied so that the crystal strain occurs. When the MgZnO having an extremely low Mg composition proportion is used as mentioned above, the magnitude and pattern of the polarization difference before the application of the compressive strain is different from those after the application as shown in Fig. 27(b), which is considered to possibly affect the generation of the two-dimensional electron gas.

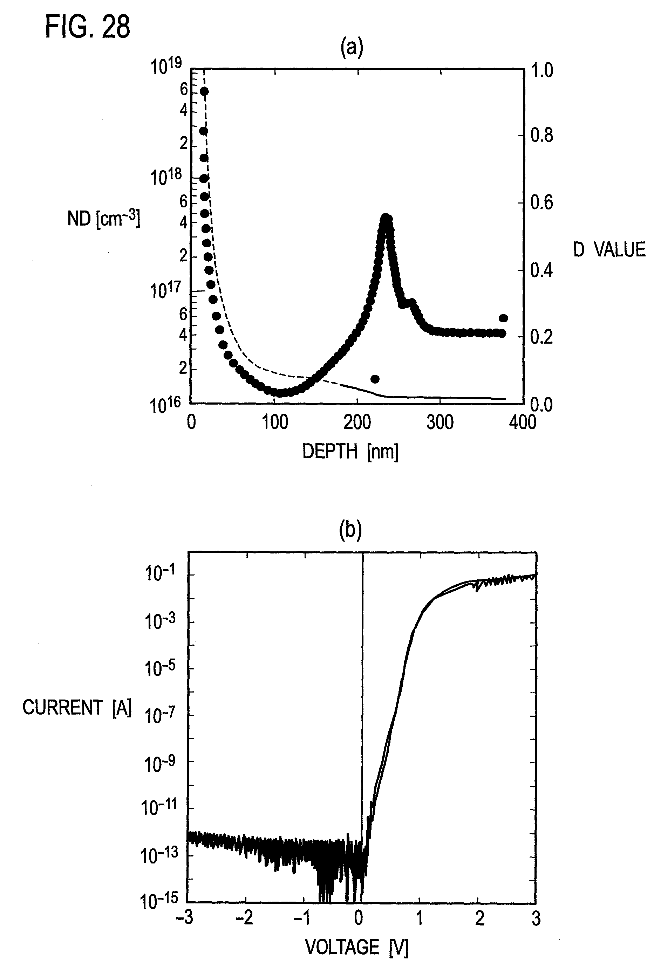

CV (capacity-voltage) measurement and IV (current-voltage) measurement are made on the ZnO-based semiconductor element in which the PEDOT/PSS is used for the organic electrode and which has the PEDOT/PSS/MgZnO/ZnO/ laminated structure. As to each of the MgZnO and the ZnO, the +C-plane is used as the growth plane. Fig. 28(a) shows results of the CV measurement, and shows the relationship between the donor concentration ND (indicated by the left vertical axis) and the distance (indicated by the horizontal axis) in the direction of depth at the PEDOT/PSS/MgZnO interface, and the relationship between a D value indicated by the right vertical axis and the distance (indicated by the horizontal axis) in the direction of depth. The D value, as typically used, represents D = G/|B|, when the inverse 1/Z of impedance Z is G+iB. Here, the Mg composition proportion of the MgZnO is set at 5.1%, and a measurement frequency is set at 1 MH. Also, black dots represent measured values.

The position of a depth around 100 nm represents the PEDOT/PSS/MgZnO interface, and it is found that the donor concentration curve is curved at this interface. Also, the fact that the CV measurement can be performed indicates that the depletion layer is present, whose capacity can be measured. Fig. 28(b) shows results of the IV measurement, and the horizontal axis represents the voltage, and the vertical axis represents the current. As can be seen from Fig. 28(b), there is a good Schottky contact between the PEDOT/PSS and the MgZnO.

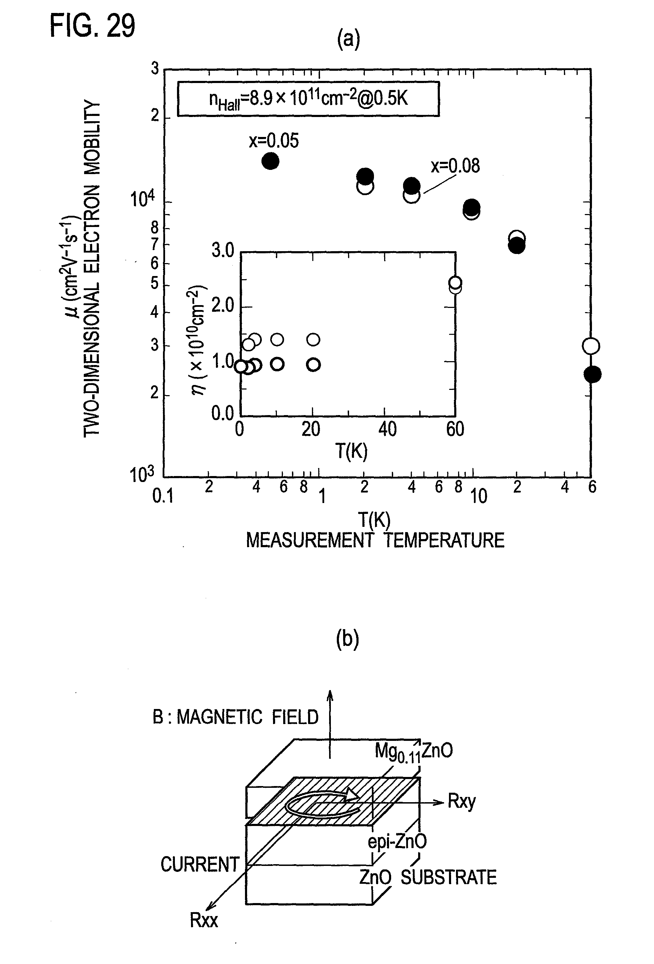

Next, Fig. 29(a) shows a state of the above-mentioned ZnO-based semiconductor element at the MgZnO-ZnO hetero interface. The vertical axis indicates two-dimensional electron mobility (cm²V⁻¹s⁻¹), and the horizontal axis indicates measurement temperature (unit: absolute temperature K). This is determined by epitaxially growing a ZnO thin film on the ZnO substrate, growing Mg_{0.11}Zn0 on the ZnO thin film, and measuring a Hall effect at an Mg_{0.11}ZnO-ZnO hetero interface, as shown in Fig. 29(b). The conduction characteristics of the two-dimensional electron gas at the hetero interface reflect the quality of the interface, that is, the purity of upper and lower crystals.

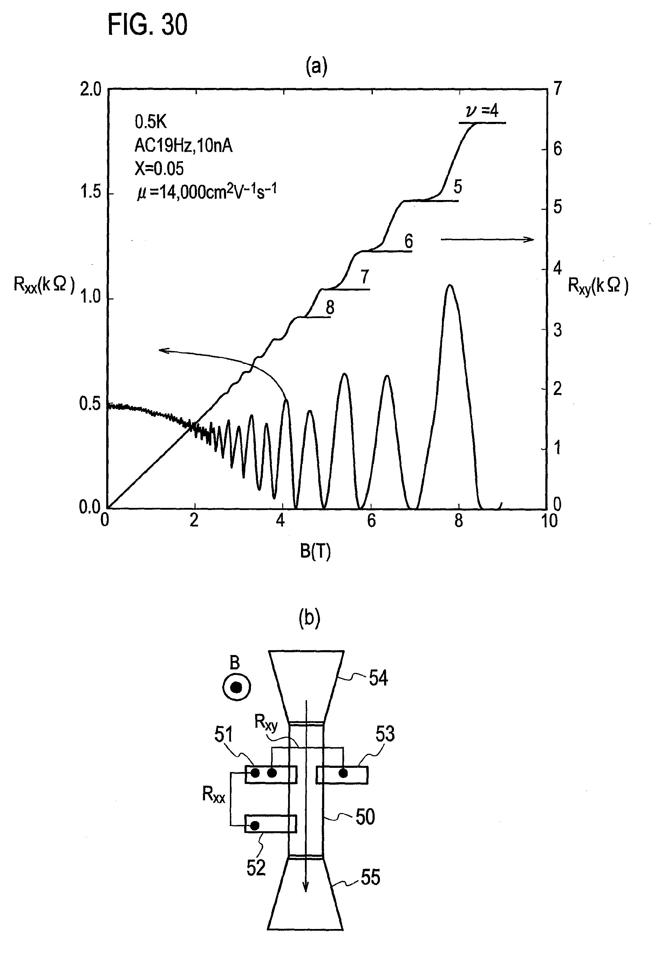

From Fig. 29(a), it is found that the electron mobility of the two-dimensional electron gas at the MgZnO-ZnO hetero interface reaches as much as 1.4×10⁴ cm²V⁻¹s⁻¹. Fig. 30(b) shows a configuration for measurement of a quantum Hall effect of the MgZnO-ZnO in the configuration shown in Fig. 29(b), and Fig. 30(a) shows measured results of the quantum Hall effect obtained by the configuration shown in Fig. 30(b). The vertical axis on the left side of Fig. 30(a) indicates longitudinal resistance Rₓₓ, and the vertical axis on the right side indicates Hall resistance R_{xy}. Also, the horizontal axis indicates magnetic field strength.

In Fig. 30(b), numeral 50 denotes the laminate of the Mg_{0.11}ZnO/ZnO/ZnO substrate described in Fig. 29(b), and portions other than the laminate 50 are etched to the ZnO thin film. Also, numerals 51, 52 and 53 denote measurement electrodes; and 54 and 55 denote application electrodes. When the current flows in a direction from the electrode 54 to the electrode 55 as shown by the arrow of Fig. 30(b) and the voltage between the electrodes 51 and 52 is measured, resistance between the electrodes 51 and 52 can be measured, and this is the longitudinal resistance Rₓₓ. On the other hand, when a magnetic field B is generated as shown in Fig. 30(b), a Hall electromotive voltage is generated across the electrodes 51 and 53. At this time, resistance between the electrodes 51 and 53 can be measured, and this is the Hall resistance R_{xy}. Measurement conditions are that the measurement temperature is 0.5 K, and the current between the electrodes 54 and 55 is 10 nA of 19-Hz alternating current.

The measured results of Fig. 30(a) show that the electrons at the MgZnO-ZnO interface exhibits distinctive characteristics when being two-dimensional. If the range of presence of the electrons is limited within two dimensions, the electrons rotate in a plane when the magnetic field B is applied thereto as shown in Fig. 29(b). If the electrons are in an orderly state such that they are never scattered while rotating, quantization occurs, and the electrons enters a state in which they get only discrete energy. While the electrons stay at this discrete localized level, the Hall resistance R_{xy} stops varying, and thus, as shown in Fig. 30(a), a region maintaining a constant value is generated for each quantum number. Also, as for the longitudinal resistance Rₓₓ, delocalized level located at the center of the localized level is also discrete, and thus, swings as shown in Fig. 30(a).

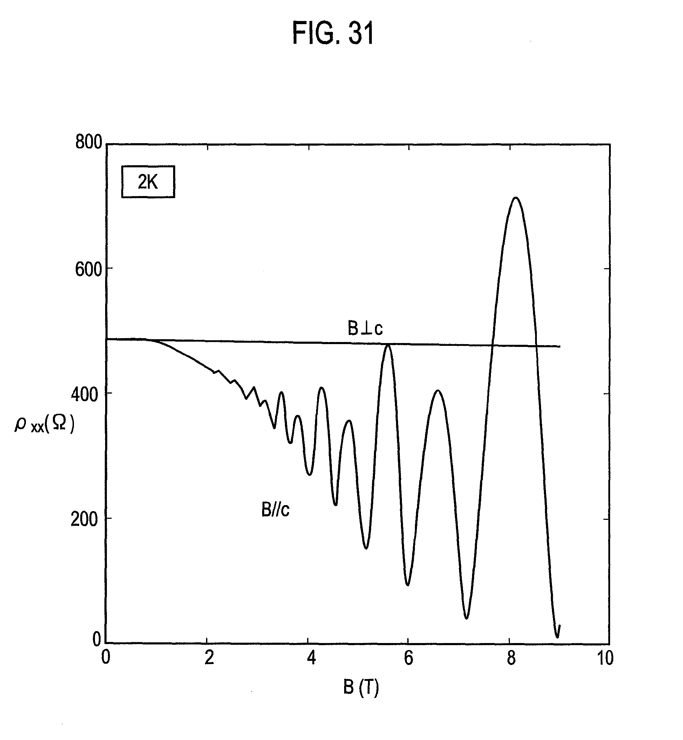

Fig. 31 is a graph showing two-dimensional properties of the two-dimensional electron gas in the configuration shown in Fig. 29(b). The vertical axis indicates the longitudinal resistance (ρₓₓ), and the horizontal axis indicates the magnetic field strength. In Fig. 31, *B* ⊥ *c* indicates a magnetic field component perpendicular to the direction of the c-axis of the MgZnO and the ZnO, and B//c indicates a magnetic field component parallel to the direction of the c-axis. The temperature at measurement is 2 K.

As shown in Fig. 31, if the two-dimensional electron gas is truly two dimensional, the magnetic field is perpendicular to the c-axis that is, the magnetic field is parallel to the thin film surface of the MgZnO or the ZnO, and thus, there is no change in magnetic resistance. Electron motion occurs due to the fact that only a vertical magnetic field component affects the magnetic resistance. Therefore, the measured results shown in Fig. 31 show that in this structure, the electrons present at the interface are surely two dimensional.

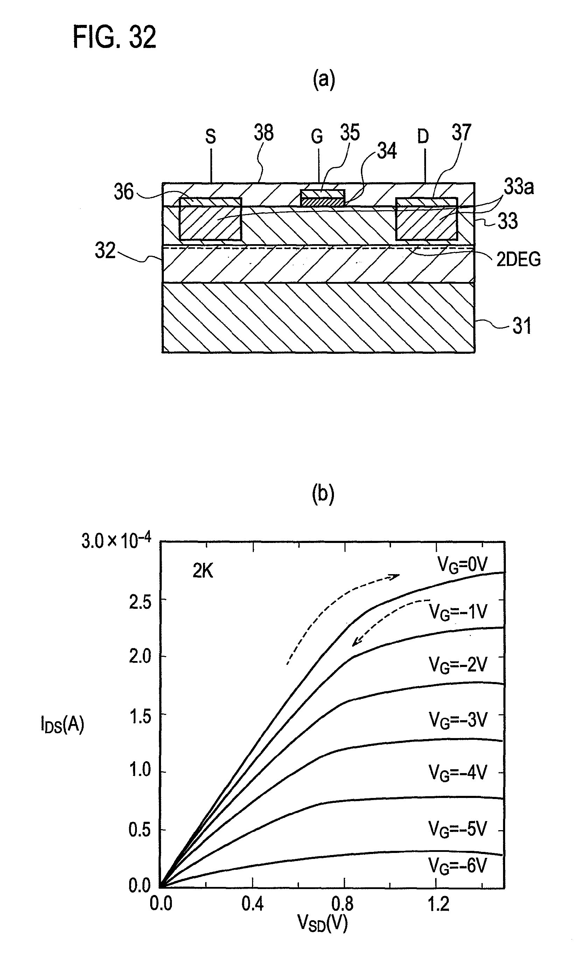

Fig. 32(a) shows the structure of the HEMT provided with a set of thin film laminated structure including the organic electrode, the ZnO-based substrate, and Mg_{X}ZnO (where 0 ≤ X < 1) and Mg_{Y}ZnO (where 0 < Y < 1) formed thereon (where X < Y). Numeral 31 denotes an MgzZnO (where 0 ≤ Z < 1) substrate; 32 denotes an Mg_{X}ZnO (where 0 ≤ X < 1) layer; and 33 denotes an Mg_{Y}ZnO (where 0 < Y < 1) layer. Here, the relationship X < Y is satisfied so that the upper MgZnO has a higher Mg composition proportion. This is for purposes of generation of the two-dimensional electron gas as described with reference to Figs. 26 and 27.

Numeral 34 denotes the organic electrode, which is formed of the PEDOT/PSS and acts as a gate electrode. Also, numerals 36 and 37 denote a source electrode and a drain electrode, respectively, both of which are made of a multilayer metal film of InZn/Ti/Au, and numeral 35 denotes a metal layer, which is made of Au. Numeral 38 denotes an interlayer dielectric, which is made of SiO₂ Also, portions of the Mg_{Y}ZnO layer 33 form an In-diffused donor-doped portion 33a. 2DEG denotes the two-dimensional electron gas region (or the electron storage region), which is a region between the dotted line in the drawing and the interface between the Mg_{X}ZnO layer 32 and the Mg_{Y}ZnO layer 33. Here, the source electrode 36 and the donor-doped portion 33a directly thereunder form a source electrode portion, the drain electrode 37 and the donor-doped portion 33a directly thereunder form a drain electrode portion, and the organic electrode 34 and the metal layer 35 form a gate electrode portion.

Fig. 32(b) shows measured results of the IV characteristic when this transistor is actually operated. The measurement temperature is 2 K. Measurement is performed at low temperature in order to clearly observe the two-dimensional properties of the electron gas region (or the electron storage region). V_{G} denotes a gate voltage; I_{DS} denotes a drain-source current; and V_{SD} denotes a drain-source voltage. Clear transistor characteristics are observed. Also, the V_{SD} bias is caused to reciprocate between 0 and about 1.5 V, and a remarkable feature is that hysteresis does not occur at all.

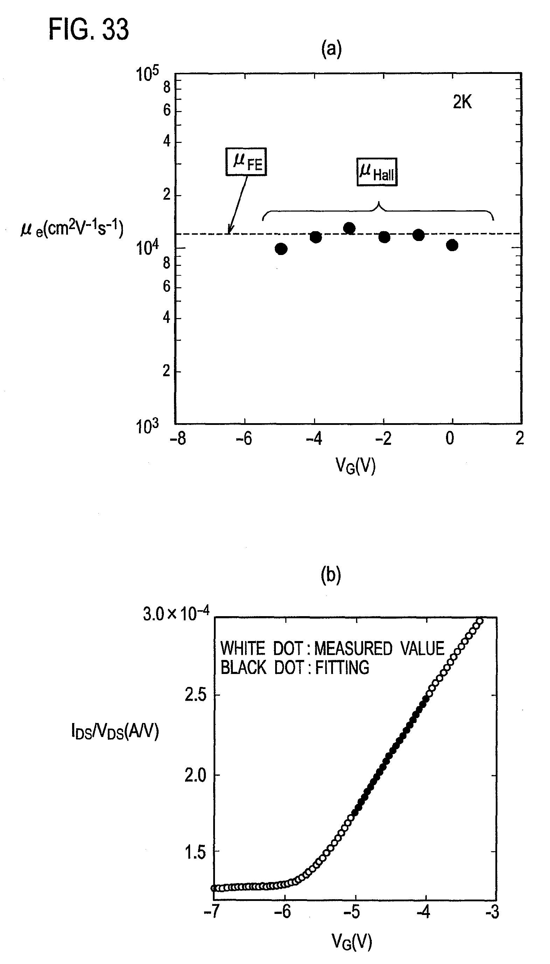

Fig. 33(b) shows the relationship between I_{DS}/V_{SD} and V_{G}, based on data shown in Fig. 32(b). White-circle dot data are measured values, and a black full-line portion is a fitting curve. The fitting curve is substantially straight, and it is found that the state of the interface is very good. Fig. 33(a) shows the relationship among the gate voltage V_{G}, field effect mobility µ_{FE}, and Hall mobility µ_{Hall}. From Fig. 33(a), it is found that the Hall mobility and the field effect mobility are substantially the same, and also from this, it is found that the state of the interface is good. The field effect mobility is typically less than the Hall mobility, because it usually contains a factor such as scattering at the interface unlike the Hall mobility.

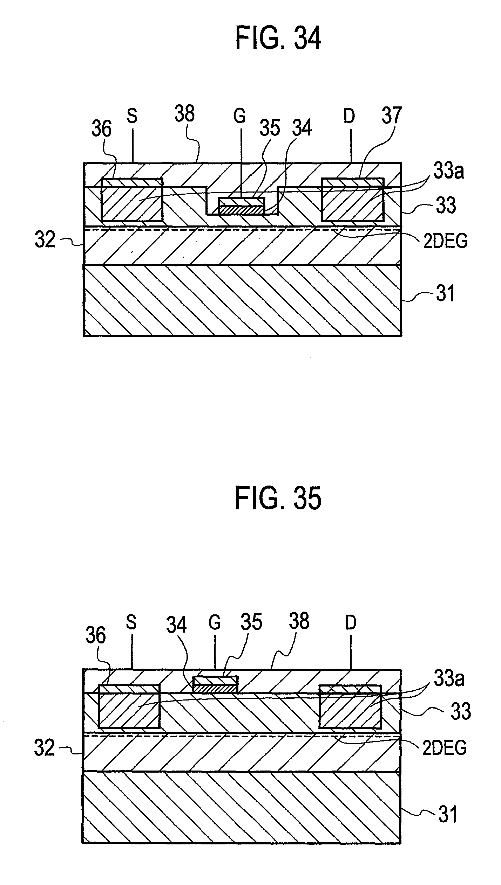

Next, specific examples of configuration of the HEMT are given. An example of a basic configuration is shown in Fig. 32(a), however, besides InZn/Ti/Au, both the source electrode 36 and the drain electrode 37 may be formed of a multilayer metal film of InZn/Ti/Al, Ti/Pt/Au, Cr/Au, or Cr/Pd/Au. Also, the metal layer 35 may be made of, besides Au, Al, Ti/Au, Ti/Al, or the like. The interlayer dielectric 37 may be formed of, besides SiO₂, SiON, Al₂O₃, or the like. For the donor-doped portion 33a, Ga diffusion, ion implantation of a Group III element, or the like may be used besides In diffusion. Hereinafter, Figs. 34 to 37 show examples of modified structures, and the above-mentioned materials of construction and others are likewise applied.

Incidentally, the MgyZnO layer 33 directly under the organic electrode 34 becomes a normally-on state if having the thickness greater than the width of the depletion layer resulting from the Schottky contact at the PEDOT/PSS/MgZnO interface, and becomes a normally-off state if having the thickness less than the width,. Here, the term "normally" means a state in which the gate electrode is 0 V. The width of the depletion layer is substantially determined by the donor concentration ND of the Mg_{Y}ZnO layer directly thereunder.

Fig. 34 shows a recess gate structure in which the thickness of the Mg_{Y}ZnO layer directly under the organic electrode 34 serving as the gate electrode is reduced. In this structure, the carrier concentration of the two-dimensional electron gas in a portion directly under the organic electrode 34 is reduced, while the carrier concentration of the two-dimensional electron gas directly under the source electrode portion and the drain electrode portion which require the small resistance can be increased, and thus, design according to the purpose of the electrode is possible.

In the transistor, if the source-gate resistance is high, a desired source-drain current cannot be obtained unless the gate voltage is set high. Therefore, a reduction in the source-gate resistance is important for the transistor. Therefore, as shown in Fig. 35, for the reduction in the source-gate resistance, a structure in which a distance between the source electrode portion and the gate electrode portion is reduced is also possible.

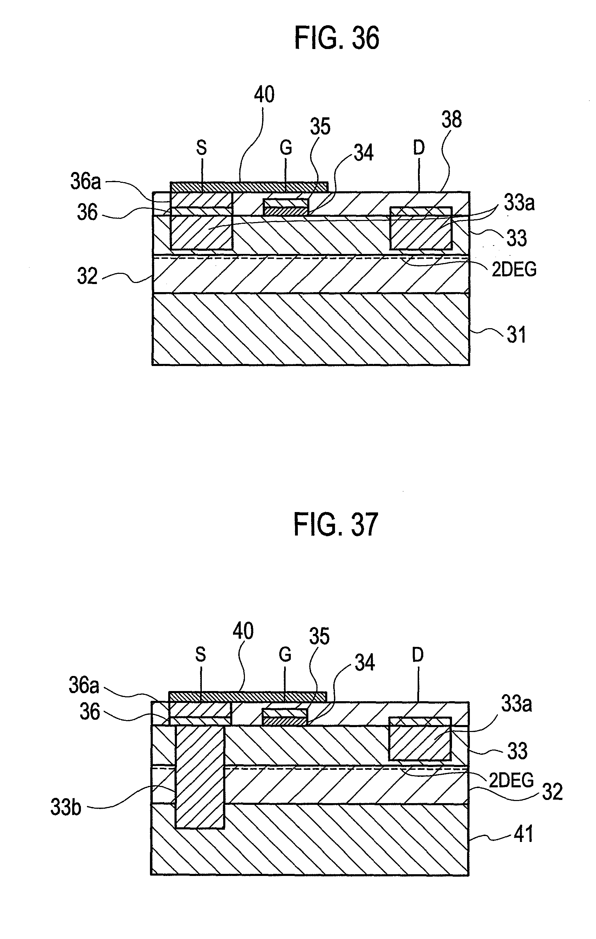

Fig. 36 shows a structure for increasing the withstand voltage. A field plate structure for use as the structure for increasing the withstand voltage was used. An electrode 36a connected to the source electrode portion is disposed in a portion of the interlayer dielectric 38, the electrode 36a is connected to a field plate 40, and the field plate 40 is formed on the interlayer dielectric 38 so as to cover the overall top of the gate electrode 34. This is done to shield the gate electrode 34 from an electric field on the drain side and thus to prevent destruction of an end portion of the gate electrode 34.

Fig. 37 shows a configuration in which a donor-doped portion 33b directly under the source electrode 36 is increased in length so as to be electrically connected to a conductive MgzZnO (where 0 ≤ Z < 1) substrate 41. As mentioned above, the field plate structures may be formed on both the front and back surfaces thereby to be a structure having a higher withstand voltage. Incidentally, the MgzZnO substrate 41 employs an undoped or Ga-doped ZnO substrate, for example, so as to be the conductive substrate.

On the other hand, the MgzZnO substrate 31 shown in Fig. 32(a) and Figs. 34 to 36 is the insulating substrate and is formed of the ZnO substrate doped with transition metal such as Ni or Cr, for example. Also, the structures of the examples shown in Fig. 32(a) and Figs. 34 to 37 may be appropriately combined according to the purpose.

A method for manufacturing the HEMT shown in Fig. 32(a) and Figs. 34 to 36 will be described below. A method for forming the MgZnO thin film on the MgzZnO substrate 31 or 41 is as mentioned above. At least a set of thin film laminated structures each formed of Mg_{X}ZnO (where 0 ≤ X < 1) and Mg_{Y}ZnO (where 0 < Y < 1) (wherein X < Y) is formed.

Then, the donor is diffused or implanted to fabricate the donor-doped portion 33a or 33b. After that, patterning is performed for the source electrode and the drain electrode, and the electrodes are formed by vapor deposition or sputtering. Incidentally, if implantation is employed to form the donor-doped portion, after the implantation, annealing is performed at 400 to 800°C, subsequently, patterning is performed for the source electrode and the drain electrode, and the electrodes are formed by vapor deposition or sputtering. If an InZn base alloy is used for the electrode, annealing is performed at 200 to 500°C.

Then, after the patterning, the PEDOT/PSS is formed. The formation of the PEDOT/PSS is accomplished by performing an ozone process to make the substrate surface hydrophilic, then performing spin coating, drying the substrate at 100 to 200°C in a nitrogen atmosphere, and thereafter dissolving the resist in an organic solvent. At this time, the PEDOT/PSS remains without dissolving in the solvent. Another method may be employed in which the PEDOT/PSS vapor deposited in vacuum or dispersed in water after the ozone process is ultrasonically processed into mist form to be fed, and is formed in thin film form.

Then, the gate electrode is vapor or sputter deposited on the PEDOT/PSS. After that, the interlayer dielectric is formed. Then, if the field plate is to be provided as shown in Figs. 36 and 37, the field plate is formed.

Incidentally, in the case of Fig. 37, the donor-doped portion 33b on the source electrode 36 side requires to be doped deeply, and thus, if the implantation is employed to form the donor-doped portion, the donor-doped portions 33a and 33b are separately subjected to photolithography, and the time for annealing after the implantation of the donor-doped portion 33b is increased.

## Claims

1. A ZnO-based semiconductor element, **characterized in that** an organic electrode is formed in contact with a ZnO-based semiconductor, and rectification characteristics are obtained between the ZnO-based semiconductor and the organic electrode.

2. The ZnO-based semiconductor element according to claim 1, **characterized in that** a work function of the organic electrode is greater than an electron affinity of the ZnO-based semiconductor.

3. The ZnO-based semiconductor element according to any one of claims 1 and 2, **characterized in that** a principal plane of the ZnO-based semiconductor on the side thereof in contact with the organic electrode is a +C-plane.

4. The ZnO-based semiconductor element according to claim 3, **characterized in that** a normal to the organic electrode is inclined at least in the direction of an m-axis with respect to a +c-axis of the principal plane.

5. The ZnO-based semiconductor element according to claim 4, **characterized in that** an angle of inclination of the normal to the organic electrode is not more than 5 degrees.

6. The ZnO-based semiconductor element according to any one of claims 1 and 2, **characterized in that** the principal plane of the ZnO-based semiconductor with which the organic electrode is in contact is any one of an M-plane and a A plane.

7. The ZnO-based semiconductor element according to claim 6, **characterized in that** the normal to the organic electrode is inclined at least in the direction of the c-axis with respect to any one of an m-axis and an a-axis of the principal plane.

8. The ZnO-based semiconductor element according to any one of claims 1 to 7, **characterized in that** at least a portion of the organic electrode is formed of a conductive polymer.

9. The ZnO-based semiconductor element according to claim 8, **characterized in that** resistivity of the organic electrode is not more than 1 Ωcm.

10. The ZnO-based semiconductor element according to any one of claims 8 and 9, **characterized in that** the conductive polymer is formed of at least one of a polyaniline derivative, a polypyrrole derivative, and a polythiophene derivative.

11. The ZnO-based semiconductor element according to any one of claims 8 and 9, **characterized in that** the conductive polymer is formed of at least one of a polyaniline derivative containing a carrier dopant, a polypyrrole derivative containing a carrier dopant, and a polythiophene derivative containing a carrier dopant.

12. The ZnO-based semiconductor element according to any one of claims 1 to 11, **characterized in that** the organic electrode has translucency in an ultraviolet region.

13. The ZnO-based semiconductor element according to claim 12, **characterized in that** the organic electrode is made of a hole conductor.

14. The ZnO-based semiconductor element according to any one of claims 12 and 13, **characterized in that** when a voltage of 3 volts is applied to the ZnO-based semiconductor element under a reverse-biased condition where a negative voltage is applied to the ZnO-based semiconductor element on the organic electrode side thereof, a reverse current is not more than 1 nanoampere under a condition where no light is applied.

15. The ZnO-based semiconductor element according to any one of claims 12 to 14, **characterized in that** the ZnO-based semiconductor is formed only of a ZnO-based substrate.

16. The ZnO-based semiconductor element according to any one of claims 12 to 15, **characterized in that** the ZnO-based semiconductor element is a photodiode.

17. The ZnO-based semiconductor element according to any one of claims 1 to 11, **characterized in that** the ZnO-based semiconductor is formed of a laminate in which at least a single ZnO-based thin film is formed on the ZnO-based substrate, and the organic electrode serves as a Schottky type gate electrode and has a transistor function.

18. The ZnO-based semiconductor element according to claim 17, **characterized in that** the laminate includes at least a set of thin film laminated structures in which two or more ZnO-based thin films are stacked on each other on the ZnO-based substrate, and a Mg_{X}ZnO layer (where 0 ≤ X < 1) and a Mg_{Y}ZnO layer (where 0 < Y < 1) are stacked in order, as viewed from the side close to the ZnO-based substrate (wherein X < Y).

19. The ZnO-based semiconductor element according to any one of claims 17 and 18, **characterized in that** an electron storage region occurring at an interface between the Mg_{X}ZnO layer and the Mg_{Y}ZnO layer in the thin film laminated structure is used as a channel region.
